# EUROPEAN PATENT APPLICATION

(11) **EP 1 508 603 A1**
(43) Date of publication of application: **23.02.2005**
(21) Application number: 03720924.4
(22) Date of filing: 17.04.2003
(51) Int. Cl.: C09K 3/00, H01M 14/00, H01L 31/04

(54) **PHOTOSENSITIZING COMPOSITION**

(30) Priority: 07.05.2002 JP 2002131521
(71) Applicant: Kabushiki Kaisha Hayashibara Seibutsu Kagaku Kenkyujo, Okayama-shi, Okayama 700-0907 (JP)
(72) Inventor: OHTAKA, H., K.K. Hayashibara S. Kagaku Kenkyujo, Okayama-shi, Okayama 700-0907 (JP); YANO, Kentaro, K.K. Hayashibara S. Kagaku Kenkyujo, Okayama-shi, 700-0907 (JP); MITEKURA, H., K.K. Hayashibara S. Kagaku Kenkyujo, Okayama-shi, 700-0907 (JP); MATSUI, F., K.K. Hayashibara S. Kagaku Kenkyujo, Okayama-shi, Okayama 700-0907 (JP)
(74) Representative: Daniels, Jeffrey Nicholas
(86) International application number: PCT/JP2003/004914
(87) International publication number: WO 2003/095582

(57) **Abstract**

The objectives of this invention are to provide a photosensitizing composition which gives an improved photoelectric conversion efficiency in photoelectric conversion elements such as solar cells, and to its uses. This invention attains the above objectives by providing a photosensitizing composition comprising two different types of organic compounds, a semiconductor electrode sensitized with the photosensitizing composition, a photoelectric conversion element, and a solar cell using the photosensitizing composition.

## Description

### Technical Field

This invention relates to a photosensitizing material, more particularly, to a photosensitizing composition which is useful in photoelectric conversion elements such as solar cells.

### Background Art

Due to recent tendency of advocating ecology-oriented civilization, solar power generation has been rapidly highlighted as a clean way of generating energy which may replace for thermal and nuclear power generations. The principle of solar power generation that irradiation to semiconductors generates an electromotive force has been known for a long time, and applied to solar cells, for example, single crystalline silicon solar cells, polycrystalline silicon solar cells, amorphous solar cells, compound semiconductor solar cells, inorganic solar cells, organic solar cells, and photoelectrochemical solar cells (wet-type solar cells). As well known, some of these solar cells have been brought to practical use, and rapidly popularized as light and simple but long life power sources in portable and home use apparatuses even though the generation power of the solar cells is not so high.

The urgent necessities residing in exploring solar cells are to reduce the power generation cost of solar cells which may supersede conventional power generation such as thermal power generation, and also to realize inexpensive, large-sized cell modules. Among the above-identified solar cells, photoelectrochemical solar cells have been deemed to bear potential advantages because an efficient electric junction is immediately given by soaking semiconductors in electrolytes, as well as because a higher photoelectric conversion efficiency is expected even in case that polycrystalline materials are used in electrodes.

Many of photoelectrochemical solar cells are employed a system where at least either electrode of one electrode pair is provided to generate an electromotive force upon absorption of the solar energy: Particularly, it has been documented that in such a solar cell the use of titanium dioxide electrodes leads to a very high energy conversion efficiency. As regards photosensitizers to compose photoelectrochemical solar cells together with such an electrode, some types of light absorptive organic compounds such as bipyridyl ruthenium complexes have been proposed in, for example, "*Solar Energy*", Vol. 23, No. 4, pp. 11-18 (1997), edited by Yoshinori Arakawa et al., and "*Chemistry on Surface*", Vol. 21, No. 5, pp. 288-293 (2000), edited by Takayuki Kitamura et al.

Conventional photoelectrochemical solar cells do not efficiently utilize the solar energy because a light absorptive organic compound is used alone as photosensitizing material and its absorption band is narrower than the wavelength region where solar cells are expected to covert the solar energy into electric energy. Combination of several light absorptive organic compounds however does not necessarily improve the photoelectric conversion efficiencies of photoelectrochemical solar cells because such a combination may render the light absorptive characteristics of solar cells dependent on an organic compound with a lower light absorbability. These have restricted the improvement of photoelectric conversion efficiencies in photoelectrochemical solar cells.

In view of these circumstances, the objectives of this invention are to provide a photosensitizing composition which efficiently absorbs the solar energy in photoelectric conversion elements such as solar cells, as well as to provide its uses.

### Disclosure of Invention

The present inventors eagerly researched and screened combinations of various absorptive organic compounds, leading to the finding that in an extended visible light region, a photosensitizing composition comprising merocyanine and coumarin dyes exhibits a higher photosensitizing property which is never attainable with an ease by either dye when it is used alone in photoelectric conversion elements.

Particularly; this invention attains one of the above-described objectives by providing a photosensitizing composition which comprises both merocyanine and coumarin dyes.

Further, this invention attains one of the above-described objectives by providing a semiconductive electrode sensitized with such photosensitizing composition.

In addition, this invention attains one of the above-described objectives by providing a photoelectric conversion element using such photosensitizing composition.

Furthermore, this invention attains one of the above-described objectives by providing a solar cell using such photosensitizing composition.

### Brief Description of Drawing

FIG. 1 is a brief figure of an example for the photoelectric conversion element according to this invention.

### Explanation of Symbols:

- 1 :: Semiconductor electrode
- 2a, 2b :: Transparent electrodes
- 3 :: Semiconductor membrane
- 4 :: Counter electrode
- 5 :: Redox electrolyte
- 6 :: External load

### Best Mode for Carrying Out the Invention

The following explains the preferred embodiments according to this invention: As mentioned heretofore, this invention relates to a photosensitizing composition comprising both merocyanine and coumarin dyes, as well as its uses. Any merocyanine and coumarin dyes can be advantageously used according to this invention, as long as their combination does not depart from the scope or spirit of this invention. Preferred merocyanine dyes are, for example, those represented by any one of General Formulae 1 to 3, while preferred coumarin dyes, for example, those represented by General Formula 4.

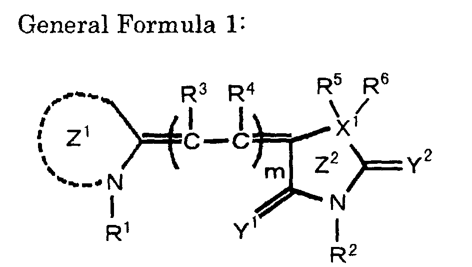

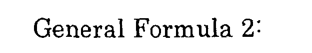

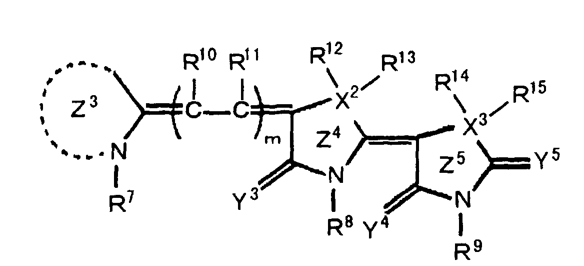

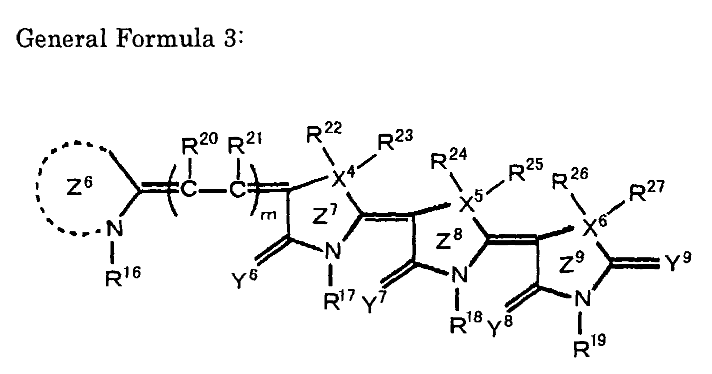

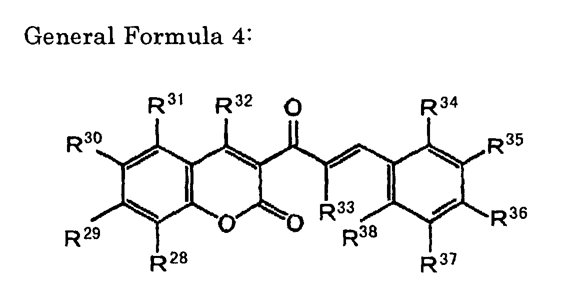

In General Formulae 1 to 3, Z¹ to Z⁹ denote the same or different heterocycle. X¹ to X⁶ independently denote carbon atom or a heteroatom of the group 15 or 16 in the periodic chart of elements, such as nitrogen, phosphorus, oxygen, sulfur, selenium, and tellurium atoms. Y¹ to Y⁹ denote the same or different heteroatom: Particular heteroatoms are, for example, those of the group 16 in the periodic chart of elements, such as oxygen, sulfur, selenium, and tellurium atoms. Therefore, as to the heterocycles in Z¹ to Z⁹, one can choose, for example, acenaphthyleno [1,2-d] thiazole, isooxazole, isoquinoline, imidazole, 2,4-imidazolidinedione, 2,4-imidazolidinedithione, imidazoline, imidazo [4,5-d] quinoxaline, imidazo [4,5-d] quinoline, imidazo [4,5-d] pyridine, indolenine, indole, oxadiazole, 2,5-oxazolidinedione, 2,5-oxazolidinedithione, oxazole, quinoline, quinolyno [2,3-d] thiazole, 2,4-thiazolidinedithione, 2,4-thiazolidinedione, thiadiazole, thiazoline, thiazole, 2-thioxo-4-imidazolidinone, 2-thioxo-5-oxazolidinone, 2-thioxo-4-thiazolidinone, 2-thioxo-5-pyrrolidinone, tetrazole, naphtho-[2,3-d]imidazole, naphtho- [1,2-d] thiazole, naphtho- [2,3-d] thiazole, triazole, pyrazole, pyridine, 2,5-pyrrolidinedione, 2,5-pyrrolidinedithione, pyrrole, phenanthreno [9,10-d] thiazole, benzimidazole, benzindolenine, benzoxazole, benzoselenazole, and benzothiaziazole.

R¹ to R²⁷ in General Formulae 1 to 3 independently denote hydrogen atom or substituents. As to the substituents in R¹ to R²⁷, one can choose, for example, aliphatic hydrocarbon groups such as methyl, ethyl, propyl, isopropyl, isopropenyl, 1-propenyl, 2-propenyl, butyl, isobutyl, *sec*-butyl, *tert*-butyl, 2-butenyl, 1,3-butadienyl, pentyl, isopentyl, neopentyl, *tert*-pentyl, 2-pentenyl, 2-penten-4-enyl, 1-methylpentyl, 2-methylpentyl, hexyl, isohexyl, 5-methylhexyl, heptyl, octyl, nonyl, dodecyl, undecyl, and octadecyl groups; alicyclic hydrocarbon groups such as cyclopropyl, cyclobutyl, cyclopentyl, cyclohexyl, cyclohexenyl, and cycloheptyl groups; aromatic hydrocarbon groups such as phenyl, *o*-tolyl, *m*-tolyl, *p*-tolyl, xylyl, mesityl, *o*-cumenyl, *m*-cumenyl, *p*-cumenyl, and biphenylyl groups; ether groups such as methoxy, ethoxy, propoxy, isopropoxy, butoxy, isobutoxy, *sec*-butoxy, *tert*-butoxy, pentyloxy, phenoxy, benzyloxy, metylenedioxy, and ethlenedioxy groups; ester groups such as methoxycarbonyl, ethoxycarbonyl, propoxycarbonyl, acetoxy, and benzoyloxy groups; amino groups such as methylamino, dimethylamino, ethylamino, diethylamino, propylamino, dipropylamino, isopropylamino, diisopropylamino, butylamino, dibutylamino, isobutylamino, diisobutylamino, sec-butylamino, tert-butylamino, pentylamino, dipentylamino, piperidino, and morpholino groups; halogen groups such as fluoro, chloro, bromo, and iodo groups; hydroxy, carboxy, and sulfo groups or their salts; cyano group; nitro group; and combinations thereof. In case that X¹ to X⁶ are a divalent or trivalent heteroatom, either or all of R⁵ to R⁶, R¹² to R¹⁵, and R²² to R²⁷ are absent. Z¹, Z³ and Z⁶ may bear one or more substituents, for example, similar to those in R¹ to R²⁷. As to the merocyanine dyes used in photoelectric conversion elements such as solar cells, R¹ and/or R² in General Formula 1, at least one of R⁷ to R⁹ in General Formula 2, and at least one of R¹⁶ to R¹⁹ in General Formula 3 are preferably carboxyl group or a substituent bearing carboxyl group, from a view point of adsorption characteristics to semiconductor electrodes.

The merocyanine dyes represented by General Formulae 1 to 3 may bear counter ions which electrically neutralize their intramolecular charges. The counter ions are arbitrarily chosen in the range of without departing from the scope or sprit of this invention: Particular examples of such counterions are inorganic cations such as sodium, potassium, calcium, and magnesium ions; and organic cations such as ammonium, tetraalkylammonium, and pyridinium ions. The symbol "m" in General Formulae 1 to 3 is an integer of zero or over: In case that "m" is zero, R³, R⁴, R¹⁰, R¹¹, R²⁰, and R²¹ are absent. In general, the absorption maxima shift to a longer wavelength side when "m" is a larger integer, while they shift to a shorter wavelength side when "m" is a smaller integer.

R²⁸ to R³⁸ in General Formula 4 independently denote hydrogen atom or appropriate substituents. The substituents in R²⁸ to R³³ are, for example, aliphatic hydrocarbon groups such as methyl, ethyl, propyl, isopropyl, isopropenyl, 1-propenyl, 2-propenyl, 2-propynyl, butyl, isobutyl, *sec*-butyl, *tert*-butyl, 2-butenyl, 1,3-butadienyl, pentyl, isopentyl, neopentyl, *tert*-pentyl, 2-pentenyl, 2-penten-4-ynyl, 1-methylpentyl, 2-methylpentyl, hexyl, isohexyl, 5-methylhexyl, heptyl, octyl, nonyl, dodecyl, undecyl, and octadecyl groups; alicyclic hydrocarbon groups such as cyclopropyl, cyclobutyl, cyclopentyl, cyclohexyl, cyclohexenyl, and cyclopeptyl groups; aromatic hydrocarbon groups such as phenyl, *o*-tolyl, *m*-tolyl, *p*-tolyl, xylyl, mesityl, *o*-cumenyl, *m*-cumenyl, *p*-cumenyl, and biphenylyl groups; ether groups such as methoxy, ethoxy, propoxy, isopropoxy, butoxy, isobutoxy, *sec*-butoxy, *tert-*butoxy, pentyloxy, phenoxy, benzyloxy, methylenedioxy, and ethylenedioxy groups; ester groups such as methoxycarbonyl, ethoxycarbonyl, propoxycarbonyl, acetoxy, and benzoyloxy groups; amino groups such as methylamino, dimethylamino, ethylamino, diethylamino, propylamino, dipropylamino, isopropylamino, diisopropylamino, butylamino, dibutylamino, isobutylamino, diisobutylamino, *sec*-butylamino, *tert*-butylamino, pentylamino, dipentylamino, piperidino, and morpholino groups; halogen groups such as fluoro, chloro, bromo, and iodo groups; hydroxy, carboxy, and sulfo groups or their salts; cyano group; nitro group; and combinations thereof. As to the merocyanine dyes used in photoelectric conversion elements such as solar cells, at least one of R³⁴ to R³⁸ are preferably carboxyl group or a substituent bearing carboxyl group(s), from a view point of adsorption characteristics to semiconductor electrodes.

Examples of the merocyanine dyes represented by General Formulae 1, 2 and 3 are those which are represented by Chemical Formulae 1 to 15, 16 to 63, and 64 to 71, while examples of the coumarin dyes represented by General Formula 4, those represented by Chemical Formulae 72 to 79. These dyes can be obtained in a desired amount by or in accordance with the method disclosed in "*Photosensitive Dye*", pp. 11 to 31, edited by Masaaki Hayami, published by Sangyo-Tosho Inc., Tokyo, Japan, 1997. In case that such dye is commercially available, it is optionally purified, then used in the photosensitizing compositions according to this invention.

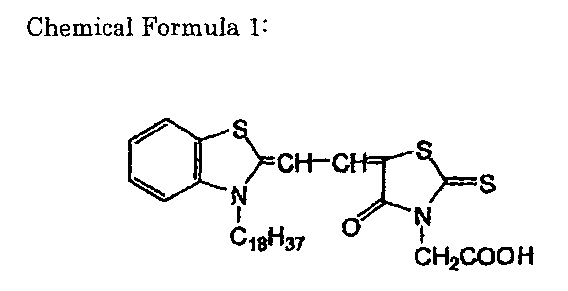

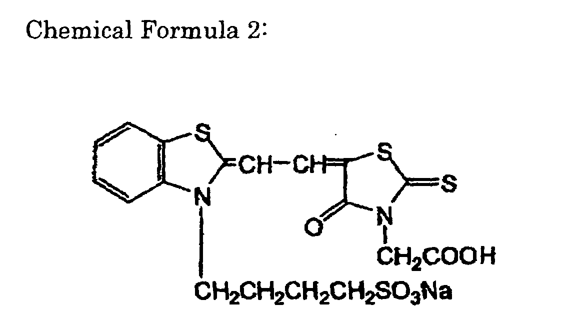

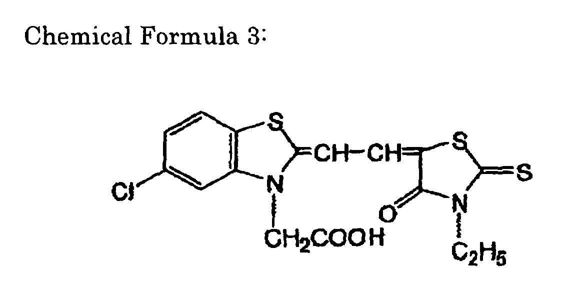

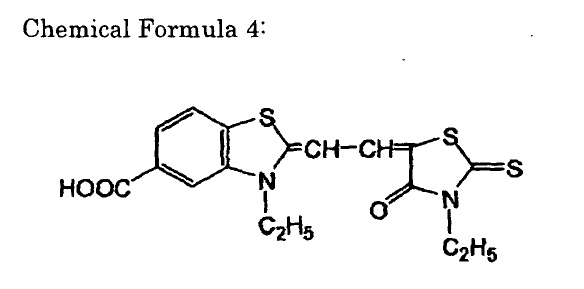

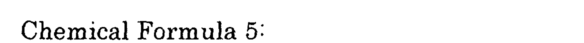

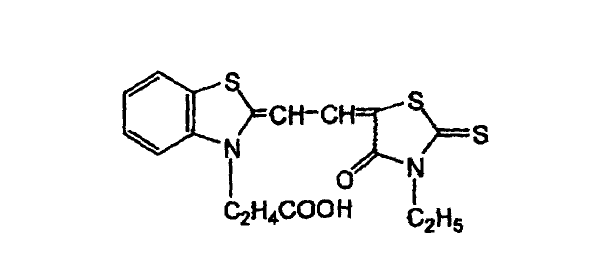

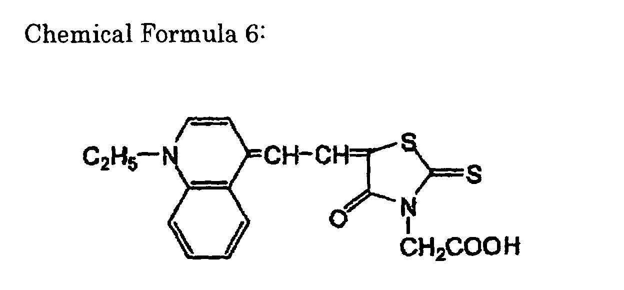

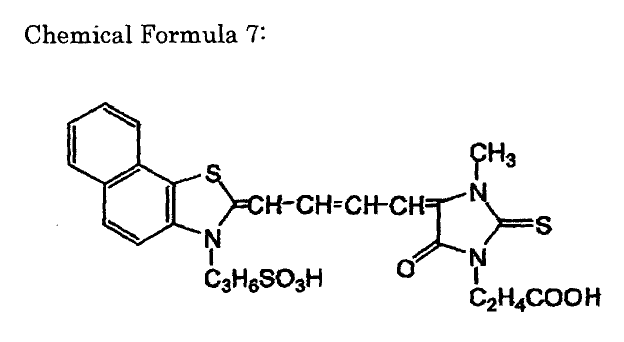

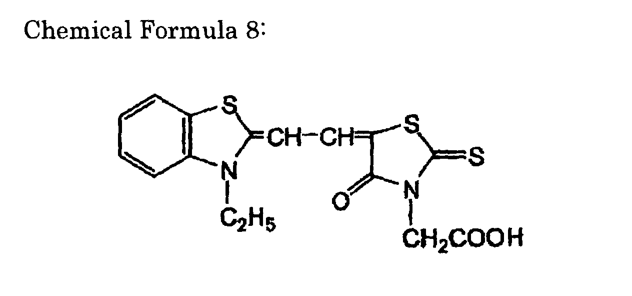

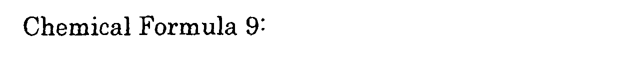

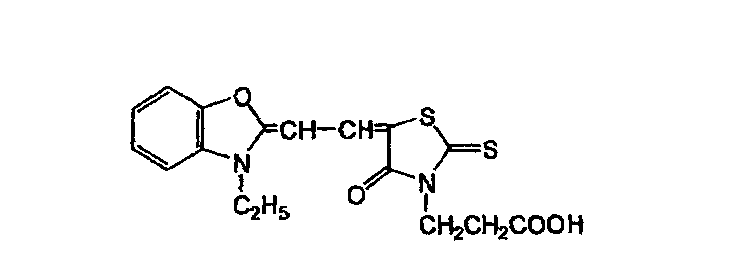

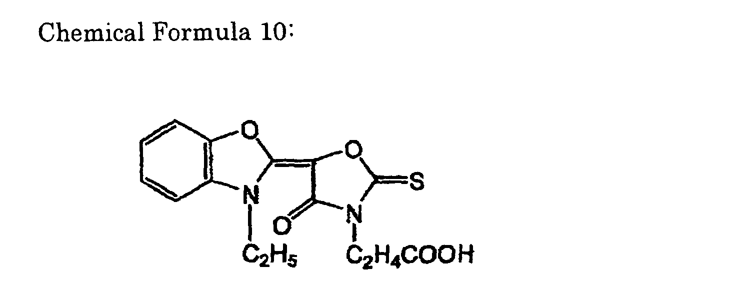

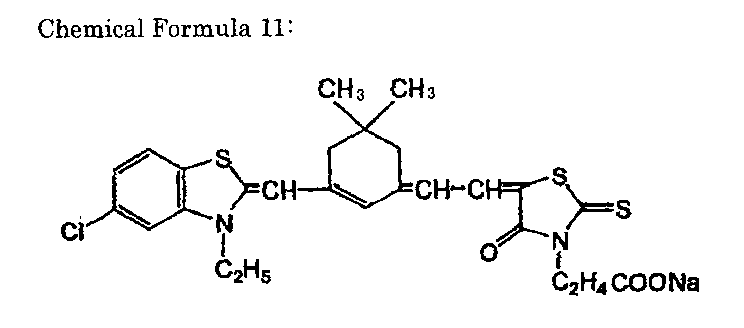

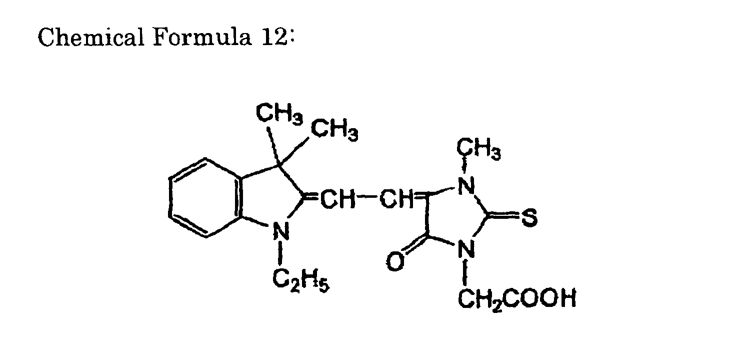

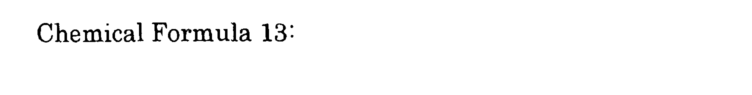

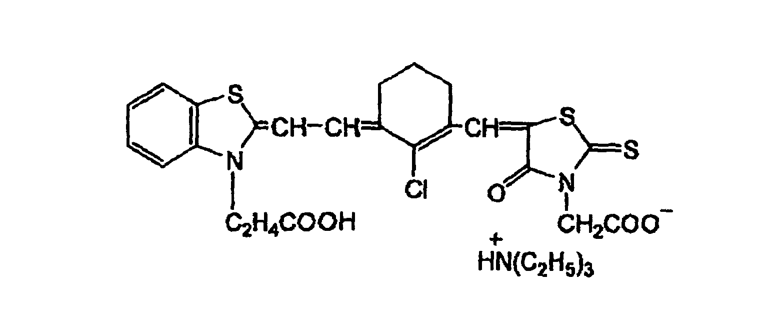

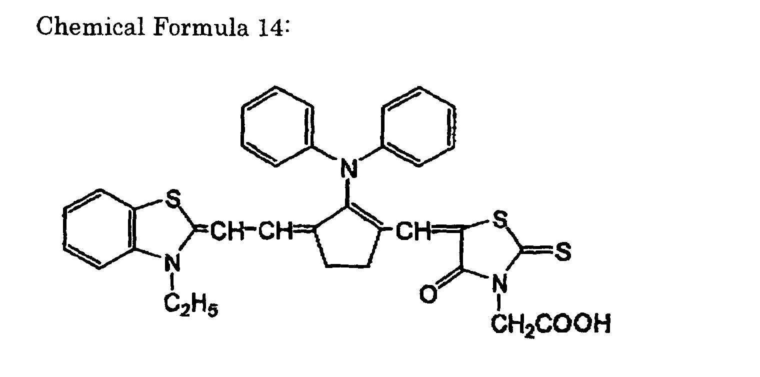

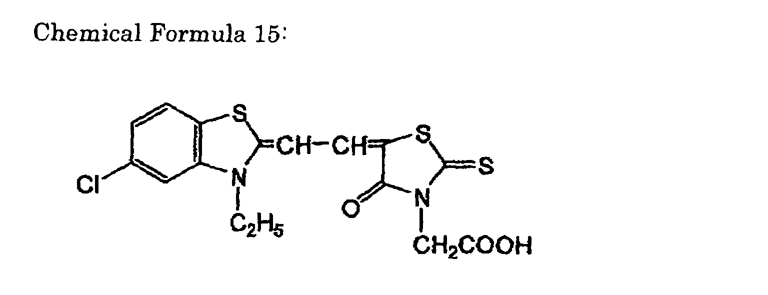

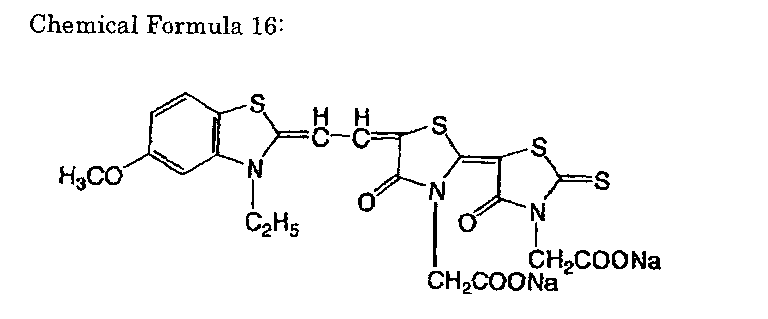

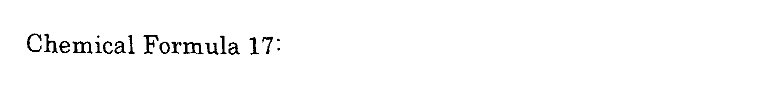

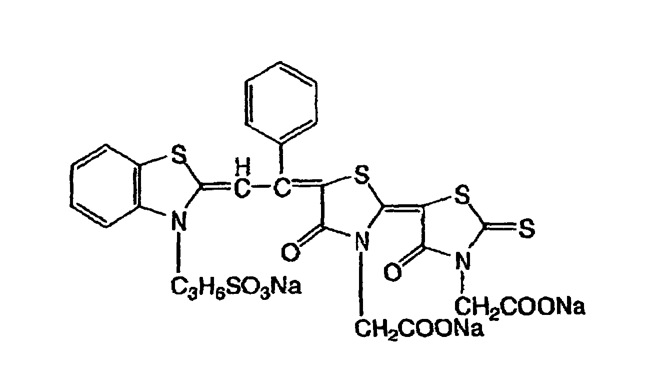

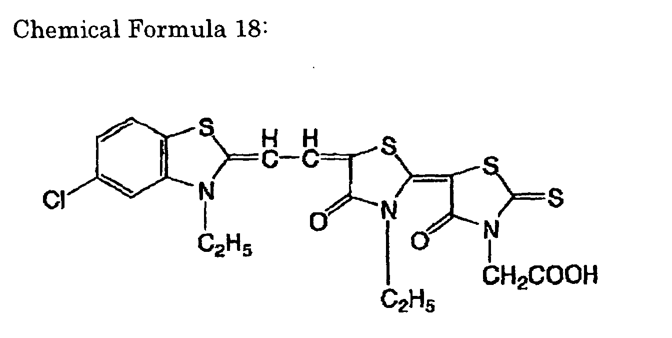

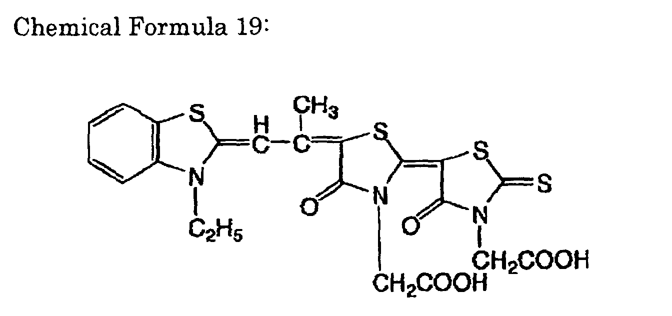

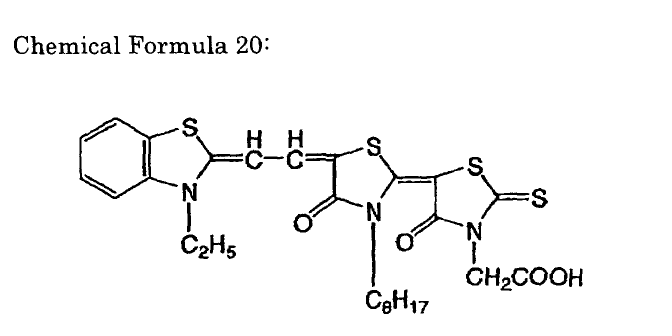

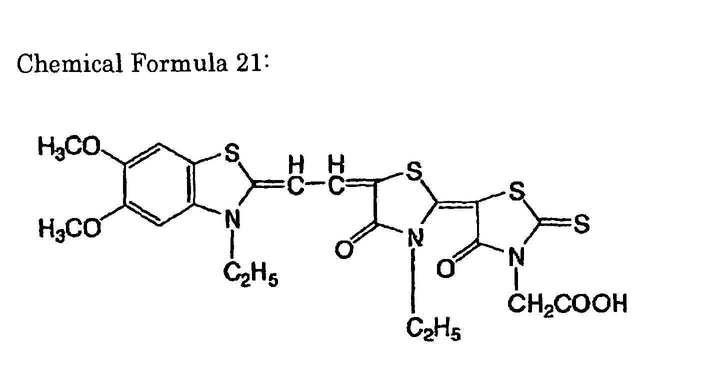

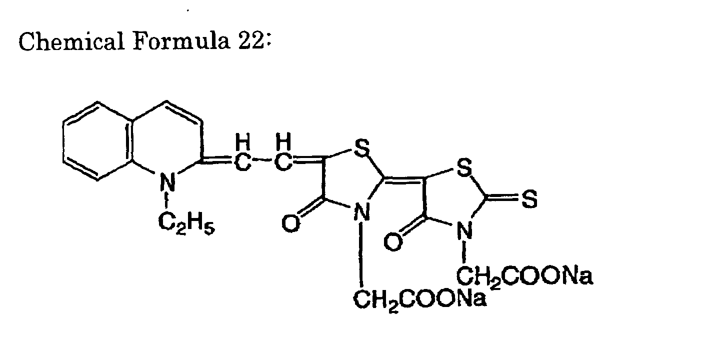

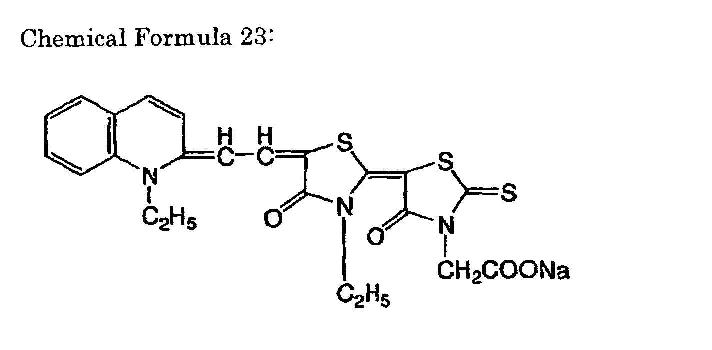

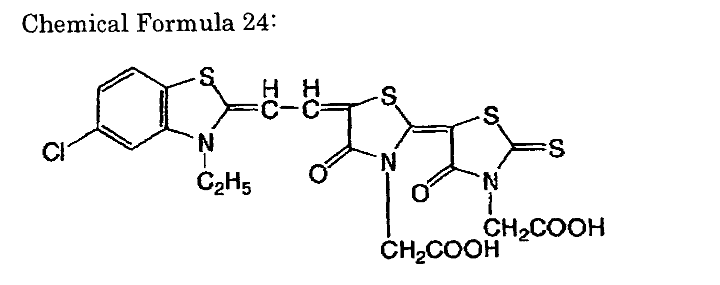

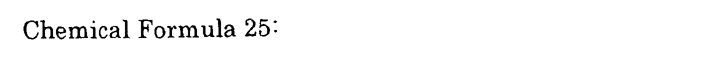

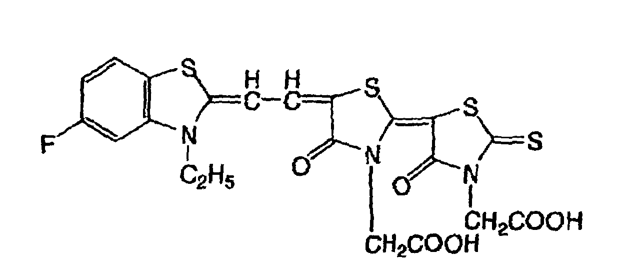

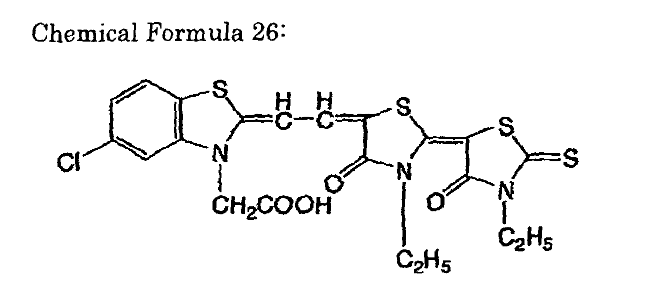

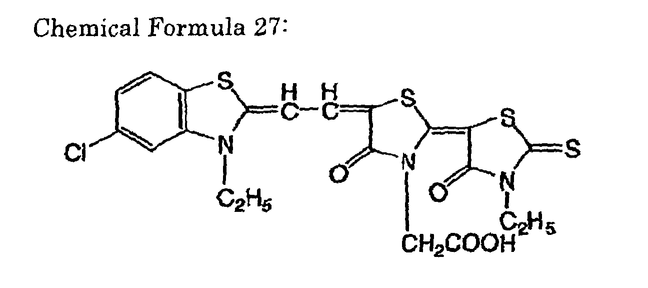

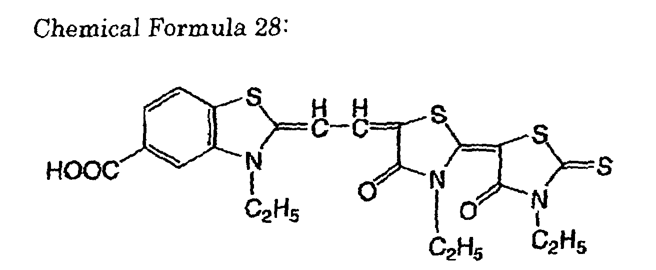

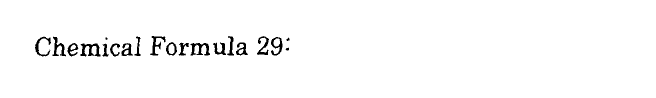

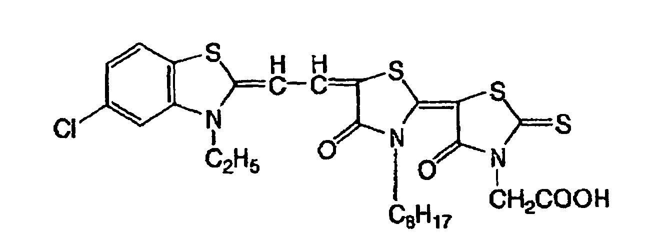

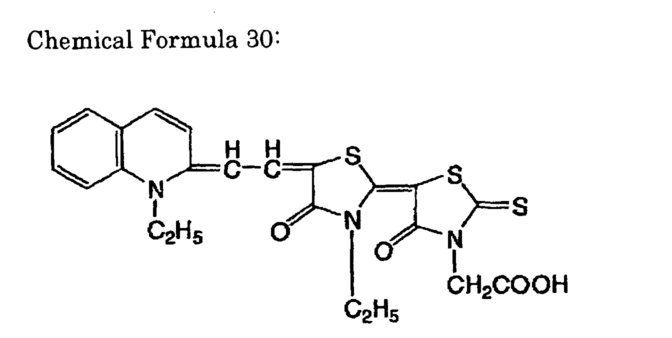

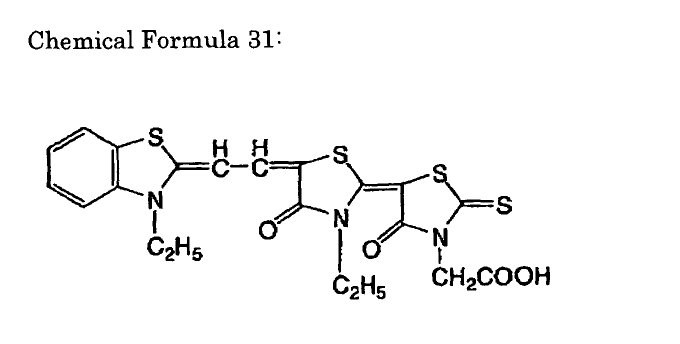

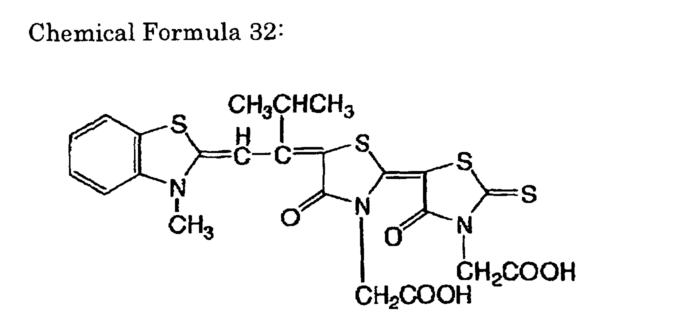

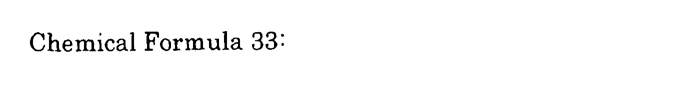

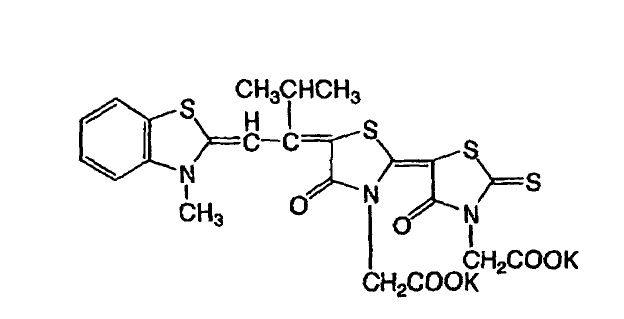

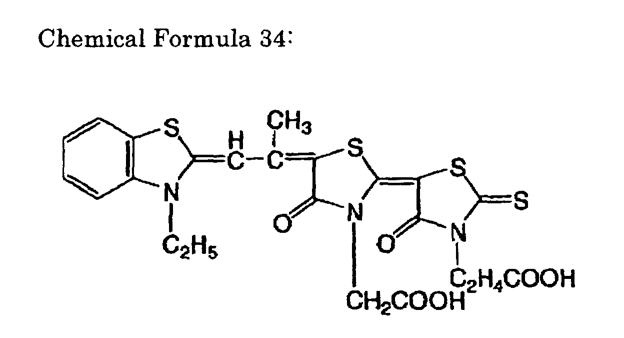

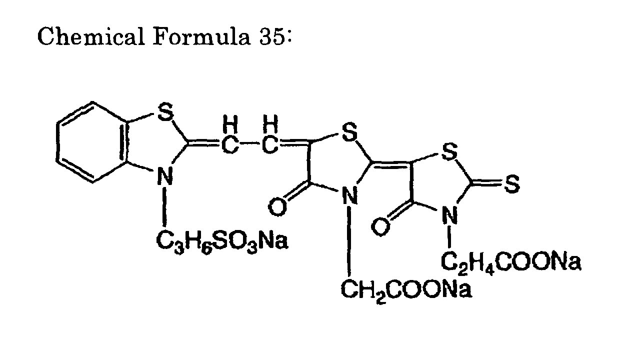

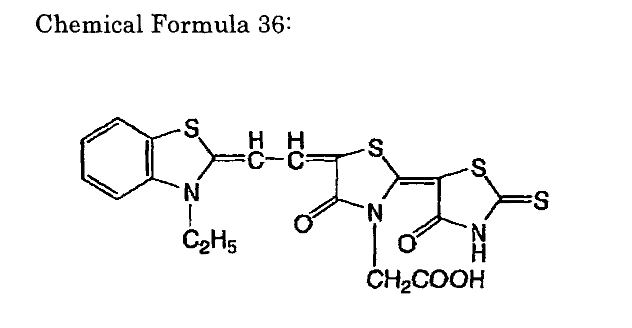

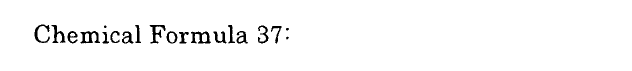

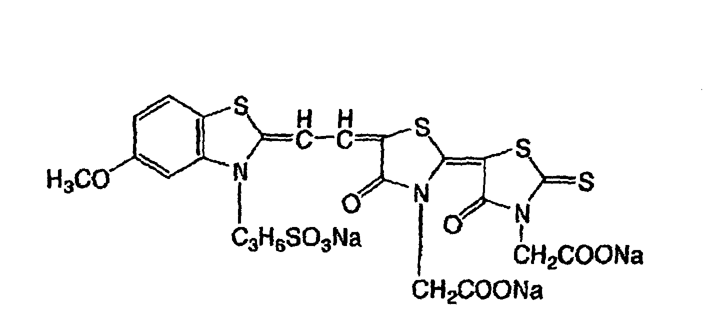

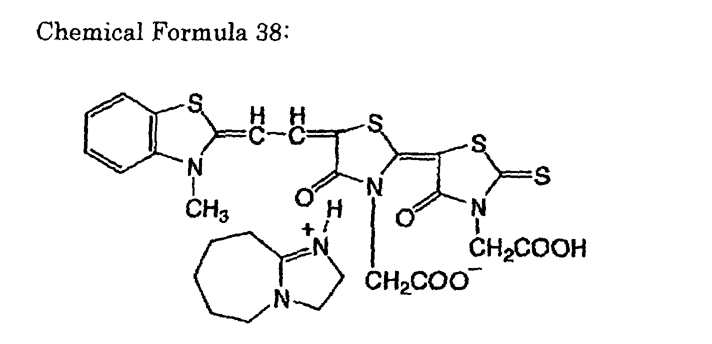

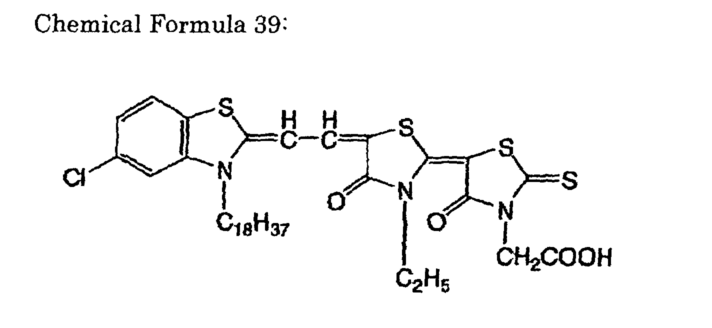

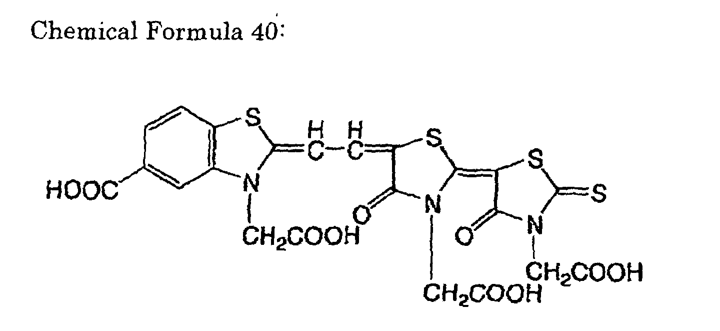

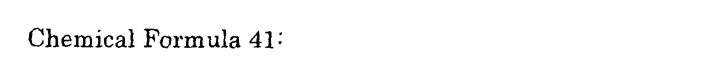

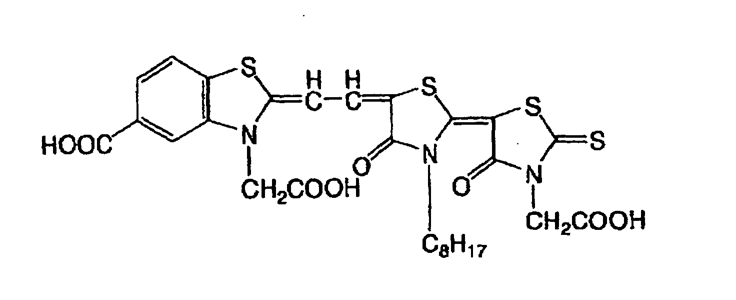

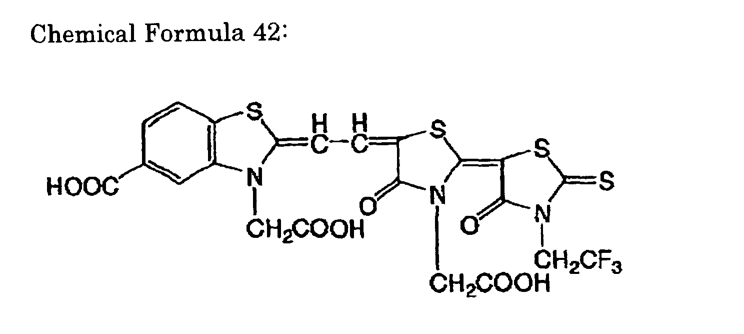

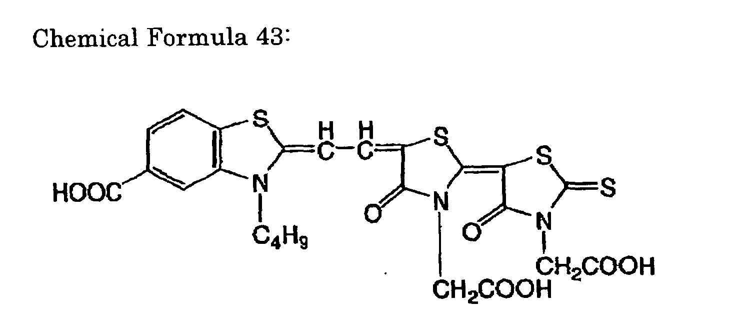

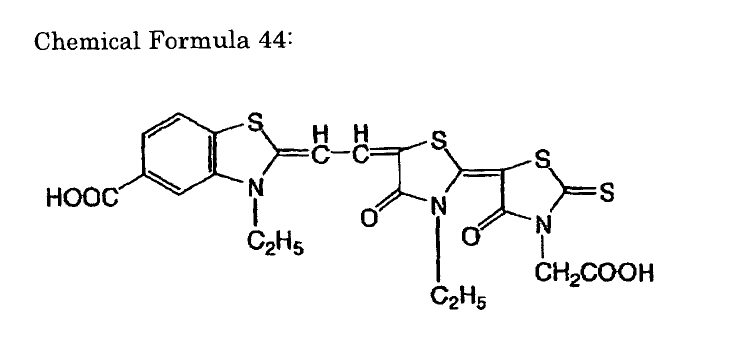

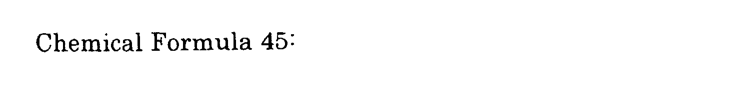

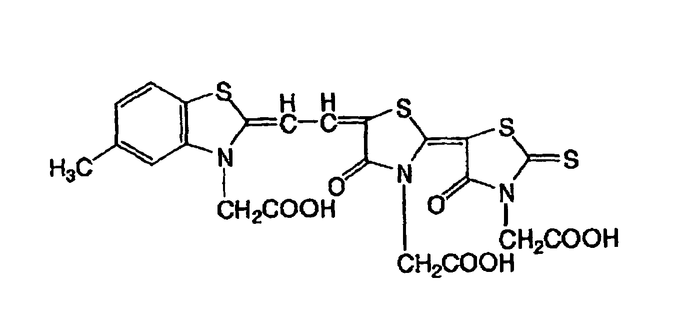

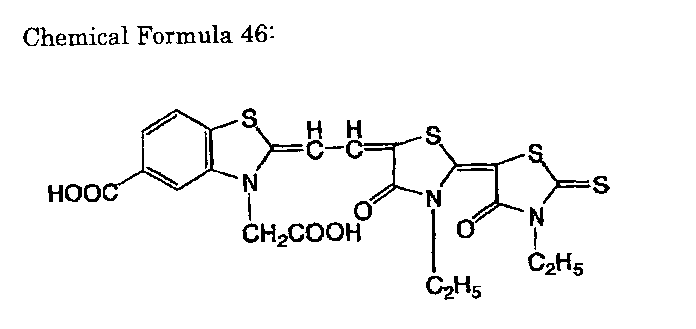

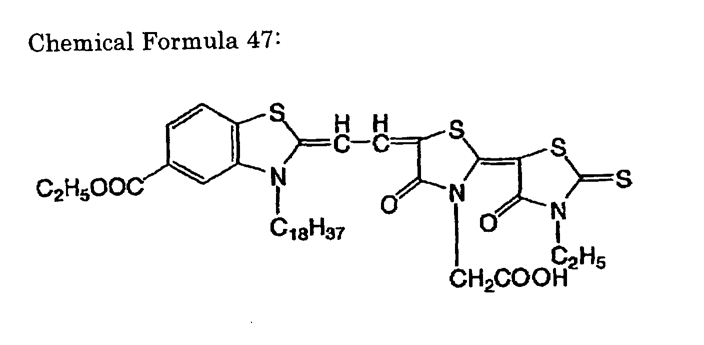

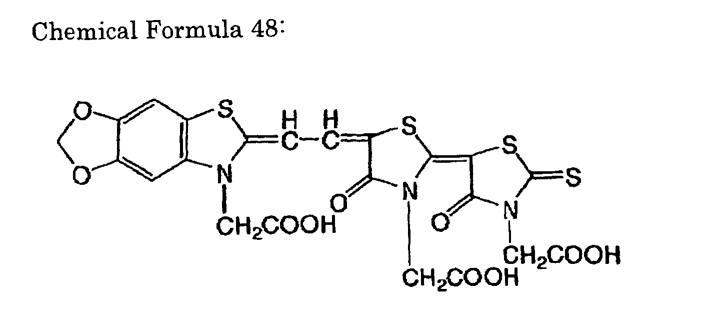

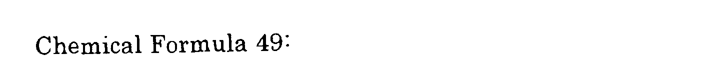

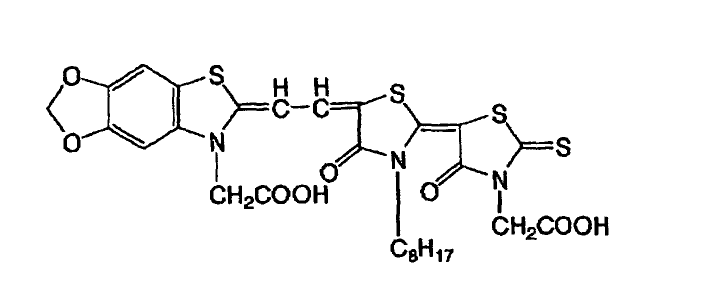

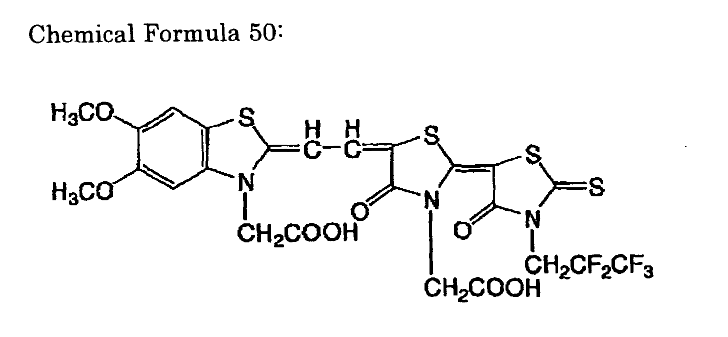

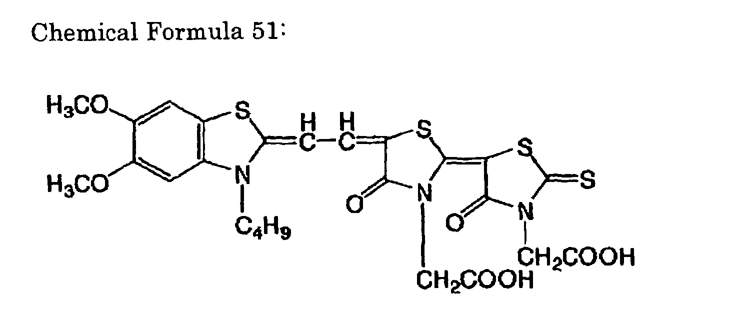

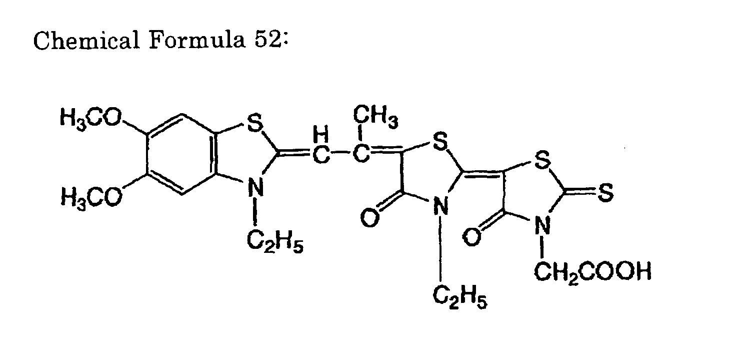

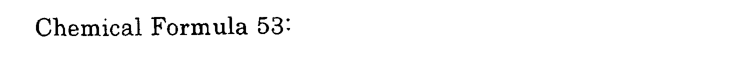

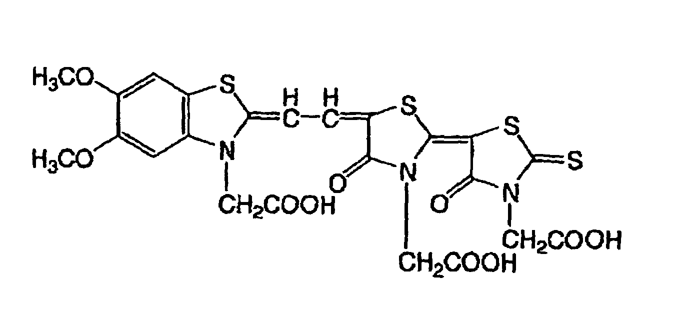

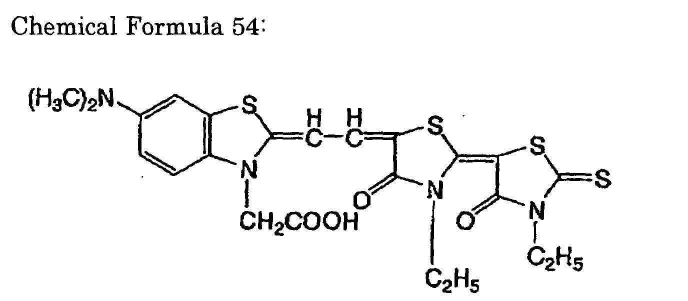

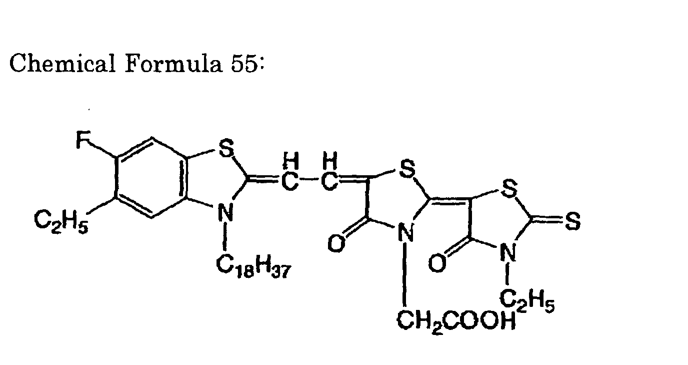

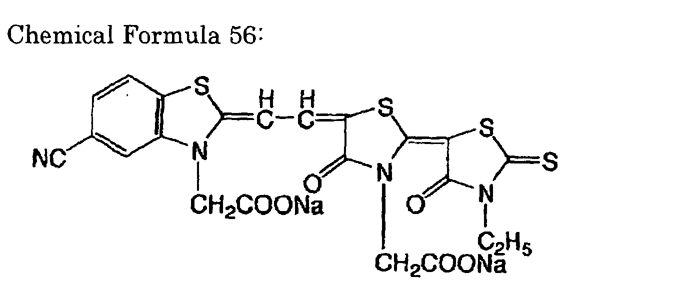

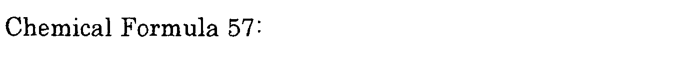

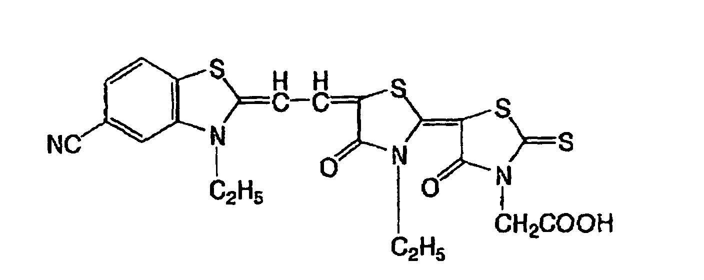

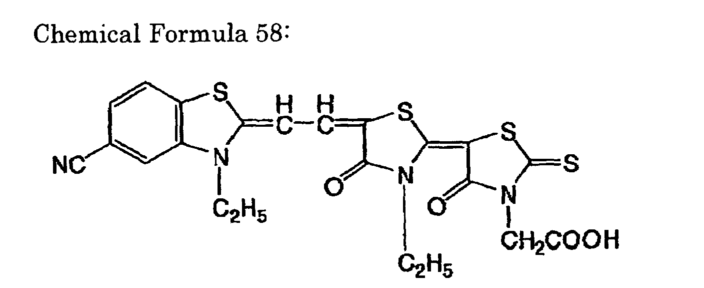

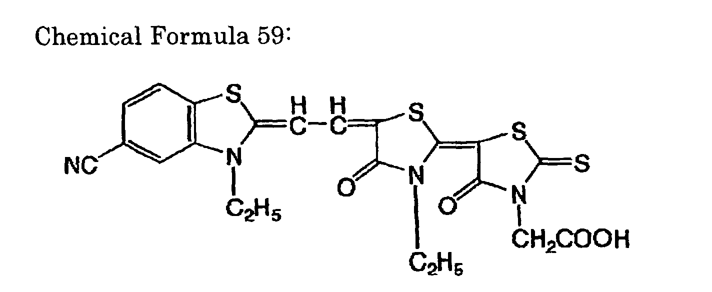

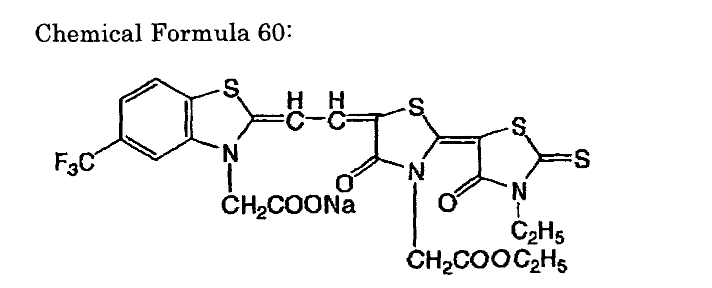

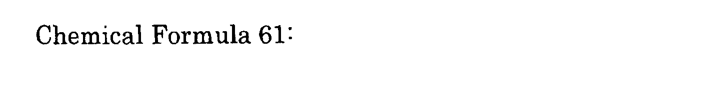

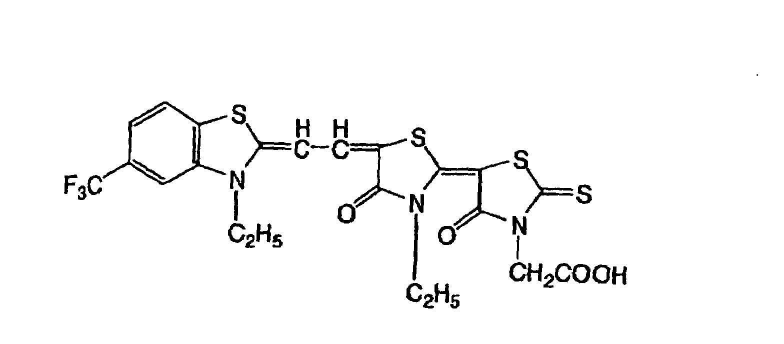

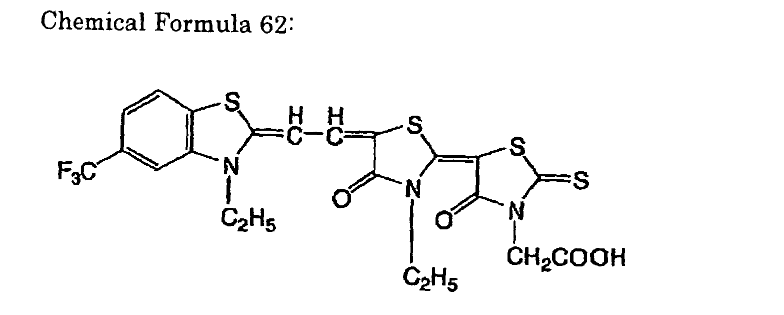

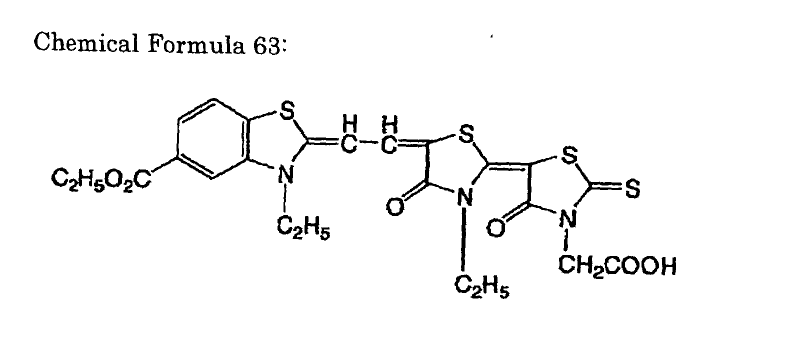

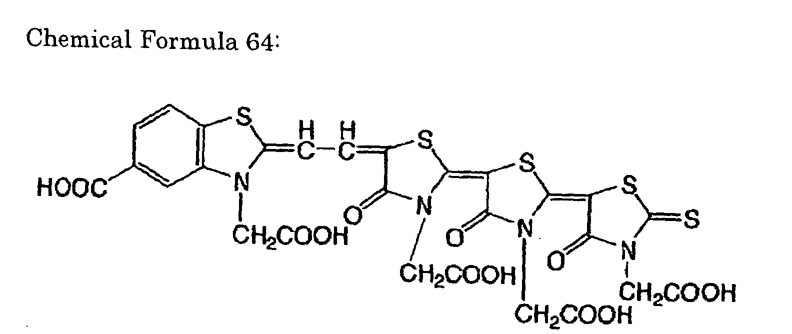

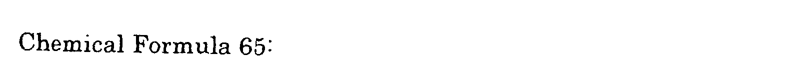

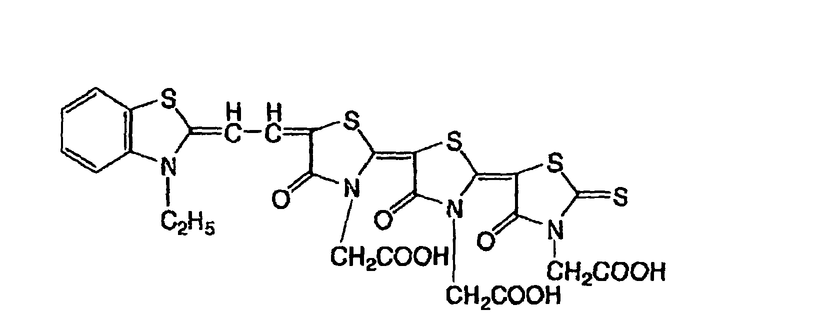

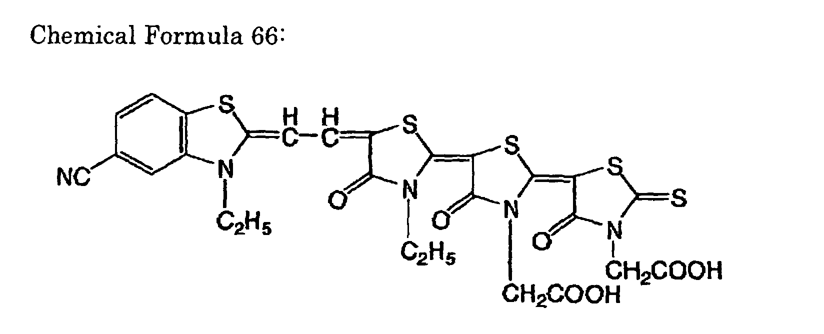

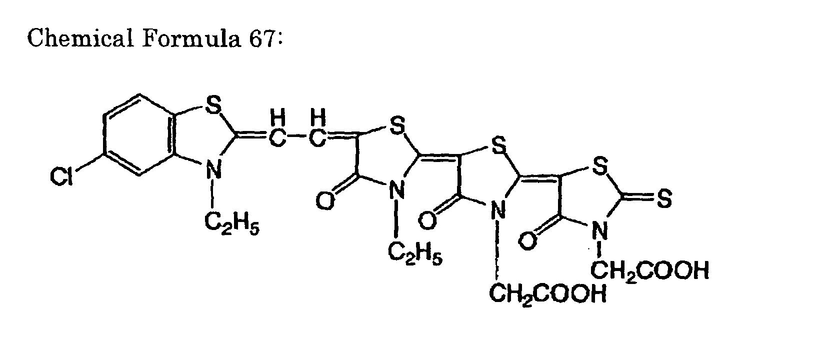

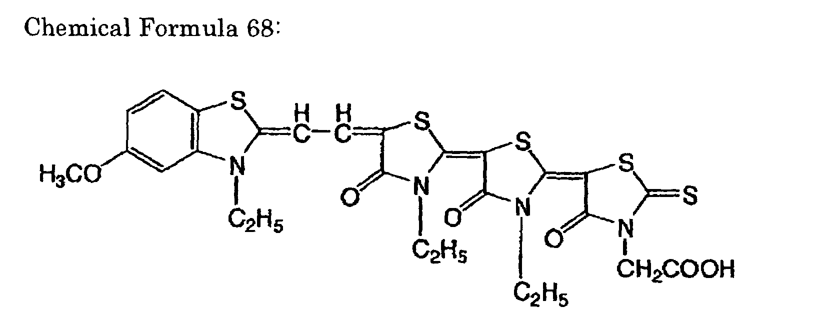

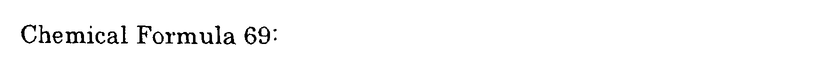

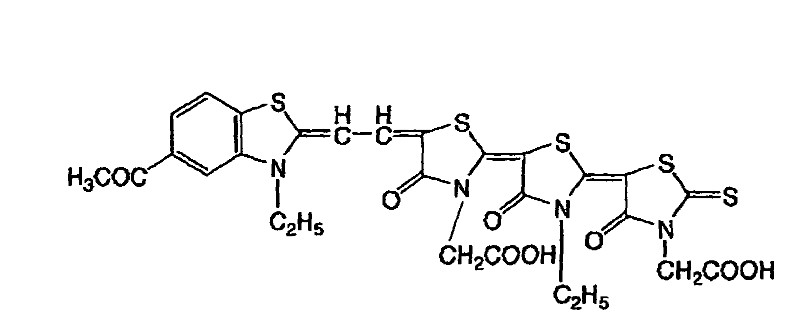

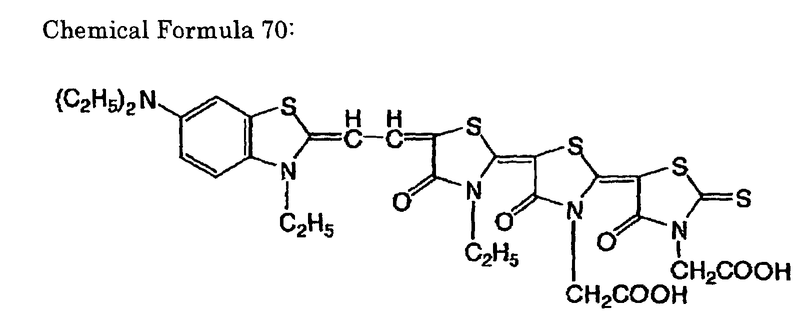

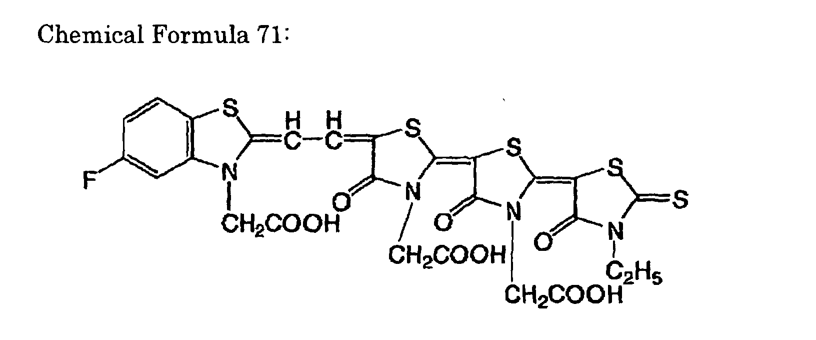

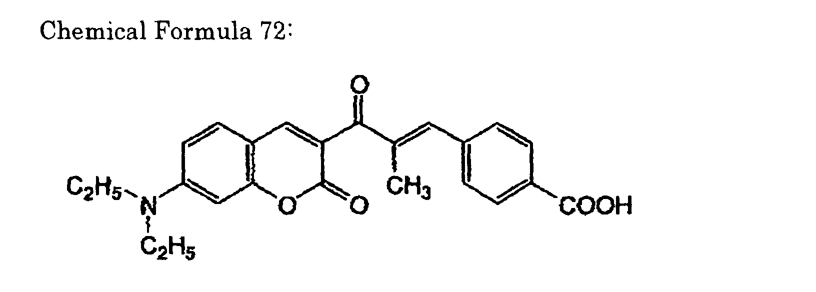

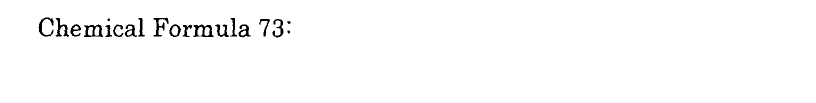

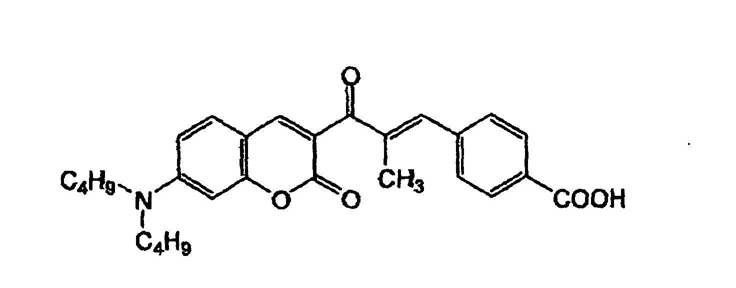

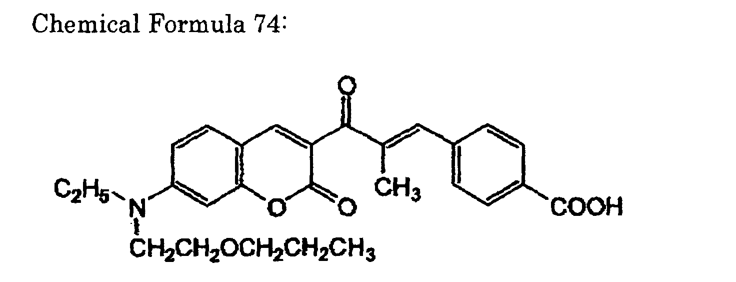

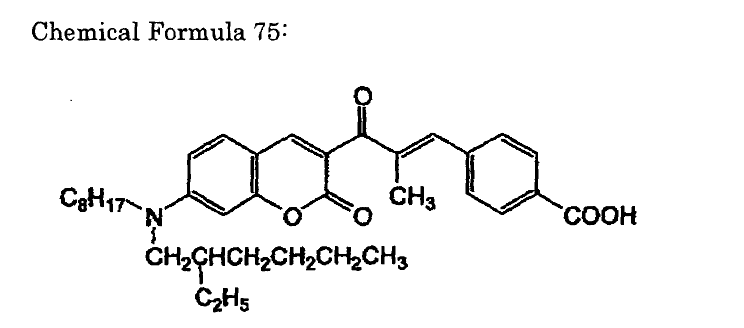

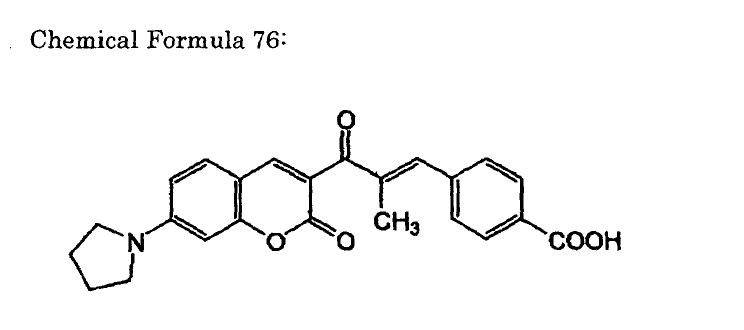

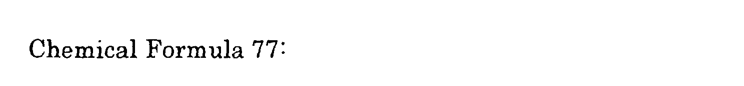

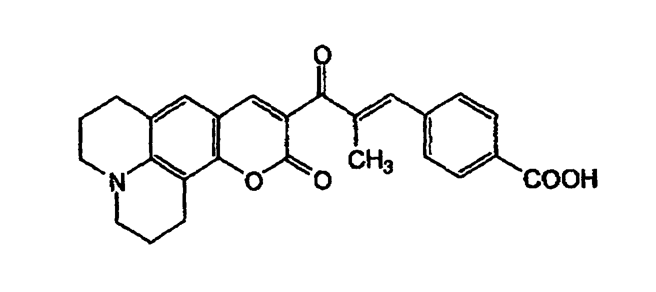

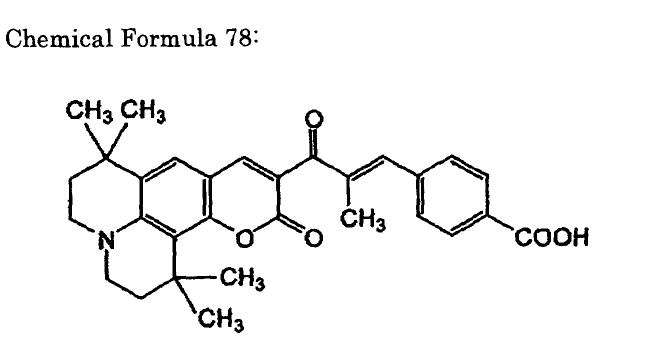

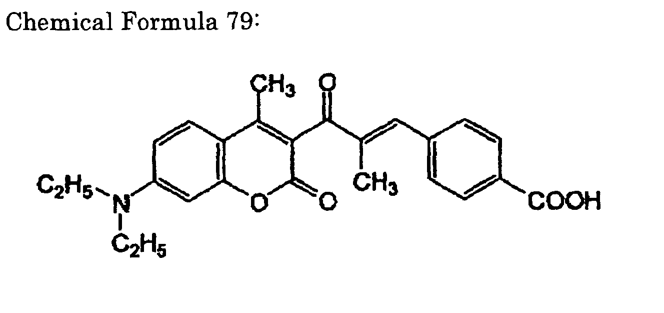

The photosensitizing compositions of this invention comprise one or more merocyanine dyes represented by General Formulae 1 to 3 and one or more coumarin dyes represented by General Formula 4 in a molar ratio of 1:100 to 100:1, usually, 1:50 to 50:1. The photosensitizing composition of this invention, prior to use, can be provided by mixing the above-identified merocyanine and coumarin dyes in a molar ratio within the above range; and alternatively by separately adding the above merocyanine and coumarin dyes in a solvent to give such molar ratio, in which the semiconductor electrodes are immersed for sensitization. The photosensitizing composition of this invention can be used in combination with, for example, one or more light resistance-improving agents, binders, dispersing agents, flame retarders, lubricants, antiatatic agents, surfacetants, thermal interference inhibitors, plasticizers, and solvents which are usually used in this art, as long as such a combination does not depart from the scope or spirit of this invention.

The following explains the use of the photosensitizing composition according to this invention: The composition is very useful in the fields which need light adsorptive materials because it exhibits light adsorptive properties in an extended wavelength region which may cover from the ultraviolet region through the visible region. Particularly, the photosensitizing composition according to this invention is very useful as material for sensitizing semiconductor electrodes to be applied to photoelectric conversion elements such as solar cells, specifically, photoelectrochemical solar cells because the composition exhibits a superior affinity to a semiconductor.

In connection with the use of the photosensitizing composition of this invention, the following explains the semiconductor electrode sensitized with the photosensitizing composition of this invention, and the photoelectric conversion element and solar cells using the semiconductor electrodes: To obtain the semiconductor electrode, semiconductor electrodes usually employed in photoelectrochemical solar cells are subjected to sensitization using the photosensitizing composition according to this invention. A semiconductor layer is prepared into a layer on a part or the whole surface of an electroconductive transparent electrode in a desired size and form, for example, sheet, column, prism, or net which may meet to final uses, after which the photosensitizing composition according to this invention is allowed to adsorb on the surface of the resultant semiconductor layer. Any transparent electrodes are feasible in this invention, as long as they have a substantial electroconductivity: Examples of such a transparent electrode are those which are prepared by coating with substantially transparent semiconductors such as tin oxides (NESA) incorporated with a small amount of fluorine or antimony, indium oxides (ITO) incorporated with a small amount of tin, and zinc oxides into a thin membrane on the surface of substantially transparent substrates in the visible region, for example, glasses, ceramics, or plastics. Among these, preferred transparent electrodes are those which are prepared by coating with tin oxides incorporated with a small amount of fluorine into a thin membrane.

To form such semiconductor layer, nano-sized semiconductive particles with a porous structure, a mean particle diameter of 5 to 500 nm, are allowed to adhere onto the surface of a transparent electroconductive electrode to give a membrane with a thickness of 0.1 to 100 µm, preferably, 1 to 50 µm; followed by sintering the electrode according to conventional method. Examples of preferred semiconductors for composing the semiconductor layer usable in this invention are compound semiconductors in general which are usually used in this art, particularly, metal oxides such as cerium, titanium, zirconium, vanadium, niobium, tungsten, iron, nickel, indium, tin, and bismuth oxides; composite metal oxides such as strontium titanate, barium titanate, potassium niobate, and sodium tantalate; metal halogen compounds such as silver iodide, copper iodide, and copper bromide; metal sulfides such as zinc sulfide, titanium sulfide, indium sulfide, bismuth sulfide, cadmium sulfide, zirconium sulfide, tantalum sulfide, silver sulfide, copper sulfide, tin sulfide, tungsten sulfide, and molybdenum sulfide; and chalcogenide compounds such as cadmium selenide, zirconium selenide, zinc selenide, titanium selenide, indium selenide, tungsten selenide, molybdenum selenide, bismuth selenide, cadmium telluride, tungsten telluride, molybdenum telluride, zinc telluride, and bismuth telluride; which can be used in an apropriate combination, if necessary. Semiconductor electrodes which are more useful in this invention are those which comprise a compound semiconductor exhibiting a plurality of size distribution peaks, disclosed in Japanese Patent Kokai No. 2001-357899, (titled "Semiconductor layer, solar cell using the same, and their production methods and uses"), applied for by the same applicant as this invention. These semiconductors are listed only for illustration but intended in no way to limit the scope of this invention thereto: One can choose p- and n-types of semiconductors, as long as the use of such semiconductor electrode does not depart from the scope or spirit of this invention.

The semiconductor electrode thus obtained can be sensitized by, for example, allowing the photosensitizing composition according to this invention to adsorb on the surface of such semiconductor electrode while immersing the electrode for at least one minute, preferably, 12 to 48 hours at ambient or higher temperatures in the solutions where the photosensitizing composition has been dissolved in an appropriate solvent to give a concentration from 0.01 mM to a saturation, preferably, 0.1 to 0.5 mM. Any solvents are feasible in this invention, as long as they dissolve the photosensitizing composition. Examples of such solvents are alcohols such as methanol, ethanol, 2,2,2-trifluoroethanol, 1-propanol, 2-propanol, 1-butanol, 2-butanol, isobutylalcohol, isopentylalcohol, and cyclohexanol; hydrocarbons such as benzene, toluene, and xylene; nitriles such as acetonitrile, propionitrile, and succinonitrile; and ethers such as diethylether, diisopropylether, tetrahydrofuran, tetrahydropyran, and 1,4-dioxiane; which all are optionally used in an appropriate combination. Among these solvents, alcohols such as methanol and ethanol, nitriles such as acetonitrile, and mixtures thereof are preferable because of their high ability to solubilize the photosensitizing composition.

Sensitization of semiconductor electrodes with the photosensitizing composition of this invention makes them very useful in photoelectric conversion elements. This invention also provides a photoelectric conversion element where such photosensitizing composition is employed: The photoelectric conversion element according to this invention comprises a semiconductor electrode presensitized with the photosensitizing composition, a counter electrode, and a redox electrolyte for soaking both electrodes.

FIG. 1 is a brief figure of an example for the photoelectric conversion element according to this invention. In FIG. 1, the reference numeral 1 represents a semiconductor electrode: As described heretofore, it can be prepared by allowing a semiconductor such as a compound semiconductor to adhere onto a part or the whole of the surface of a transparent electrode 2a to give a layer, and allowing the photosensitizing composition to adsorb on the surface of the formed semiconductor layer 3 to give a sensitizable layer.

The reference numeral 4 represents a counter electrode which can be usually prepared with a method similar to that in the semiconductor electrode 1 in such a manner that a metal such as iron, ruthenium, cobalt, rhodium, nickel, platinum, copper, silver, gold, zinc, aluminum, or tin; carbon; or a semiconductor similar to that in the semiconductor electrode 1 is allowed to adhere onto a part or the whole surface of an electroconductive transparent electrode 2b to give a layer with an arbitrary thickness with a usual method such as vacuum deposition, chemical vapor deposition, spattering, atom layer epitaxy, embrocation, or immersion.

The reference numeral 5 represents a redox electrolytic solution: A redox electrolyte to be incorporated in the solution is, for example, a mixture of iodine and iodide compounds such as imidazolium iodide derivatives, lithium iodide, potassium iodide, and tetraalkylammonium iodides; and a mixture of bromine and bromine compounds such as imidazolium bromide derivatives, lithium bromide, potassium bromide, and tetraalkylammonium bromides which give a redox system, for example, an iodine, iron, zinc, chromium, vanadium, sulfide ion, and anthraquinone systems when dissolved in an appropriate solvent.

Any solvents can be used in the redox electrolyte 5 according to this invention, as long as they have a practical handleability, stability, and dissolvability for such redox electrolyte. Examples of preferred solvents are nitriles such as acetonitrile, methoxyacetonitrile, propionitrile, methoxypropionitrile, and succinonitrile; esters such as ethylene carbonate, and propylene carbonate; amides such as N,N-dimethylformamide, N,N-dimethylacetamide, and hexamethylphosphoric triamide; ethers such as tetrahydrofuran, tetrahydropyran, 1,4-dioxane, and dicyclohexyl-18-crown-6; amines such as pyridine; nitro compounds such as nitromethane; and sulfur-atom-containing compounds such as dimethylsulfoxide which may be used in combination, if necessary. Such a redox electrolytic solution in the photoelectric conversion element is intended in no way to limit the scope of this invention to redox electrolytes in liquid form, and it can be constructed into a semi-solid electrolyte which has been gelled with a gelatinizer, and alternatively an electrolyte which has been solidified with a polymer such as a polyethylene oxide derivative.

The photoelectric conversion element according to this invention may be provided with a spacer which is to prevent any physical contacts between the semiconductor 1 and the counter electrode 4. Materials for such spacer are, for example, non-electroconductive materials including plastics such as polyester, polycarbonate, polysulfone, poly(methylpolyacrylate), polypropylene, and polyethylene; glasses such as silica glass, soda lime glass, aluminosilicate glass, aluminoborosilicate glass, borosilicate glass, barium silicate glass, and barium borosilicate glass; and ceramics such as quartz and earthenware. Such spacer is provided by forming one or more materials into a membrane, film, or sheet with a thickness of at least one micro meter, preferably, 10 to 50 µm: It may be omitted in case that cells to house the photoelectric conversion element have a structure which inherently prevents physical contacts between electrodes in photoelectrochemical solar cells.

The following explains the mechanism of the photoelectric conversion element according to this invention: A photosensitizing composition S/S, adsorbed on the surface of the semiconductor electrode 1, absorbs light energy to form a photosensitizing composition S/S* in an excited state when the light energy (hν) is transferred to the semiconductor electrode 1 in the photoelectric conversion element shown in FIG. 1. The excited electrons in the photosensitizing composition S/S* are injected into the conduction band level of the semiconductor layer 3, and transferred through the semiconductor electrode 1 to the transparent electrode 2a as a back-contact. While, such photosensitizing composition S/S however is oxidized by losing the electrons, it is regenerated by reducing with the reception of electrons from a redox ion R/R such as I⁻ ion in the redox electrolyte 5. Either ion of one redox ion pair such as I³⁻ ion is reduced again on the surface of the counter electrode 4, thus iodo ion is regenerated. Such an electron flow permits a current to energize the external load 6.

The solar cells according to this invention can be formed into a shape, structure, or size which may meet to final uses. With respect to photoelectric conversion efficiency and electromotive force, most preferable solar cells are prepared into those where a plurality of cells adjacent each other, provided by compartmentalizing a transparent electrode layer on the surface of an opposed transparent substrate, are electrically connected in series, for example, disclosed in the specification of International Application No. PCT/JP01/11381 published under the Patent Cooperation Treaty (International Publication No. WO02/052654, titled "Solar cells") applied for by the same applicant as this invention.

The photosensitizing composition according to this invention is useful as a photosensitizing agent for sensitizing polymerizable compounds and polymerization initiators in photochemical polymerization because the composition efficiently absorbs a visible light, as described heretofore.

In the field of photochemical polymerization, the photosensitizing composition according to this invention is usually used in combination with a polymerizable compound, a polymerization initiator, and a binder resin. As to polymerizable compounds which can be applied to the photosensitizing composition according to this invention, one can choose, for example, monomers, oligomers, prepolymers, and their mixtures; which have intramolecularly at least one of polymerizable multiple bonds such as ethylene double bond. Preferred examples of the above polymerizable compounds are acrylic acid, allylamine, allyl sulfonic acid, vinyl alkyl carboxylate, crotonic acid, styrene, N-vinylimidazole, N-vinylcarbazole, vinyl pyridine, vinyl sulfonic acid, vinyl phosphonic acid, fumaric acid, maleic acid, methacrylic acid, methacryl sulfonic acid, and their derivatives and salts; which are usually used in photopolymerizable compositions. The polymerizable compounds to be applied with the photosensitizing composition according to this invention are intended in no way to limit the scope of this invention to the above-mentioned polymerizable compounds, and this invention includes any polymerizable compounds which can be photochemically polymerized by using the photosensitizing composition according to this invention.

The polymerization initiators used in this invention are, for example, organic peroxides such as di-*tert*-butylperoxyisophthalate, 3,3',4,4'-tetrakis(*tert*-butylperoxycarbonyl)benzophenone, ethyl methyl ketone, 2,5-dimethyl-2,5-di(*tert*-butylperoxy)hexane, di-*tert*-butylperoxide, 2,5-bis(hydroperoxy)-2,5-dimethylhexane, *tert*-butylhydroperoxide, butyl-4,4-bis(tert-butylperoxy)valerate, and 1,1-bis(*tert*-butylperoxy)-3,3,5-trimethycyclohexane; hydrocarbon halides such as 2,4,6-trichloromethyl-s-triazine; and usual polymerization initiators in photochemical polymerization, such as bisimidazole, benzoylalkylether, iron-arene complex, titanocene compound, N-phenylglycine, and diphenyl iodonium salt, which may be used in an appropriate combination.

Varying depending upon uses, any binder resins are feasible in this invention, as long as they are commonly used in photopolymerizable compositions: Particular binder resins are, for example, poly-N-vinylpyrrolidone, polyvinylacetate, polyvinylbutyral, polyvinylcarbazole, polystyrene polymethylmethacrylate, polyethylene oxide, polybutylmethacrylate, styrene-maleiate, polymethylmethacrylate-methacrylic acid, and poly-N-vinylpyrrolidone-glycidylmethacrylate.

A photopolymerizable composition using the photosensitizing composition according to this invention is usually prepared by incorporating 1 to 1,000 parts by weight, preferably, 10 to 500 parts by weight of the above-mentioned polymerization compound to one part by weight of the photosensitizing composition; and optionally incorporating up to 1,000 parts by weight, preferably, up to 500 parts by weight of the binder resin(s) and 0.1 to 100 parts by weight, preferably, 1 to 10 parts by weight of the polymerization initiator(s) to one part by weight of the photosensitizing composition. In addition, the photopolymerizable composition can be arbitrarily incorporated with thermal polymerization inhibitors of quinones or phenols, for example, hydroquinone, pyrogallol, or 2,6-*tert-*butyl-*p*-cresole; plasticizers, for example, saturated or unsaturated carboxylates such as phthalates or adipates; coloring agents; preserving agents; stabilizing agents; surface protecting agents; lubricating agents; and coat assisting agents. The polymerization initiator(s) and/or the binder resin(s) may be omitted, considering the types of the merocyanine and coumarin dyes, as well as the uses of the photopolymerizable composition.

The photopolymerizable composition thus obtained is usually subjected to uses where it is dissolved in an appropriate solvent, coated on the surface of arbitrary substrates, and dried. As to the solvents, one can choose hydrocarbons such as pentane, hexane, cyclohexane, petroleum ether, petroleum benzine, isooctane, benzene, toluene, and xylene; halides such as carbon tetrachloride, chloroform, 1,2-dichloroetane, 1,2-dibromoethane, trichloroetylene, tetrachloroethylene, chlorobenzene, and α-dichlorobenzene; alcohols and phenols such as methanol, ethanol, 1-propanol, 2-propanol, 2,2,2-trifluoroethanol, 1-butanol, 2-butanol, isobutyl alcohol, isopentyl alcohol, cyclohexanol, ethylene glycol, propylene glycol, 2-methoxyethanol, 2-ethoxyethanol, phenol, benzyl alcohol, cresole, diethylene glycol, triethylene glycol, and glycerin; ethers such as diethyl ether, diisopropyl ether, tetrahydrofuran, tetrahydropyran, 1,4-dioxane, anisole, 1,2-dimethoxyethane, diethylene glycol dimethyl ether, dicyclohexyl-18-crown-6, methylcarbitol, ethylcarbitol, propylene glycol monomethyl ether, and propylene glycol monomethyl ether acetate; ketones such as acetone, ethyl methyl ketone, and cyclohexanone; esters such as ethyl acetate, butyl carbonate, amyl acetate, ethyl propionate, ethylene carbonate, propylene carbonate, and triethyl phosphate; amides such as formamide, N-methylformamide, N,N-dimethylformamide, N-methylacetoamide, N,N-dimethylacetoamide, and hexamethylphosphoric triamide; nitriles such as acetonitrile, propionitrile, succinonitrile, and benzonitrile; nitro compounds such as nitromethane, and nitrobenzene; amines such as ethylenediamine, pyridine, piperidine, and morpholine; sulfur-atom-containing compounds such as dimethylsulfoxide, and sufolane; and water; which may be used in an appropriate combination.

The substrates which are commonly used in this art may be used in the field of photochemical polymerization, dependently upon their uses. Particular substrates are provided by, for example, forming metals such as alminium, magnesium, copper, zinc, chromium, nickel, iron, and their alloys; papers such as woodfree, art, and released papers; inorganic substances such as a glass, and ceramic; plastics such as polyethylene phthalate, polyethylene, poly(methyl methacrylate), poly(vinyl chloride), vinyl chloride-vinylidene chloride copolymer, polystyrene, nylon, cellulose acetate, and cellulose acetate butylate into a sheet or film which may be laminated each other, if necessary.

The polymerization methods usable in this invention may be, but are not limited to, photoinitiation polymerization such as a radical polymerization, ionic polymerization, and ring-opening polymerization where irradiation is involved only in an initiation stage; or photopolyaddition polymerization where irradiation is involved in growing stage. As to exposure light sources in such polymerization, one may choose, for example, usual light sources such as sunbeam, carbon arc, high-pressure mercury lamp, xenon lamp, metal halide lamp, fluorescent lamp, and tungsten lamp; gas state lasers such as an argon ion laser, krypton ion laser, helium-cadmium laser, and helium-neon laser; semiconductor lasers such as a CdS laser; solid-state lasers such as a distributed feedback laser and the Bragg reflection Cd-YAG laser; and visible lasers which usually have an oscillation in the wavelength region of around 400 to 550 nm. The photopolymerizable composition prepared by mixing the photosensitizing composition according to this invention is advantageously used in the fields, for example, information recordings including facsimiles, copying apparatuses, and printing apparatuses; printings such as flexographies and gravure printings; and printing circuits such as photoresists.

The preferred embodiments according to this invention are explained with reference to the following Examples:

### Example 1

### Photosensitizing composition

A composition, having a sensitizing property in the visible region, was obtained by mixing the merocyanine dye (an absorption maximum wavelength of 525 nm, ε =9.70 × 10⁴), represented by Chemical Formula 4, and the coumarin dye (an absorption maximum wavelength of 421 nm, ε =3.81 × 10⁴), represented by Chemical Formula 72, in a molar ratio of 38:62.

The photosensitizing composition of this example is useful as a material for sensitizing semiconductor electrodes in photoelectric conversion elements such as solar cells, as well as for photosensitizing polymerization compounds and polymerization initiators in photochemical polymerization.

### Example 2

### Photosensitizing composition

A composition, having a sensitizing property in the visible region, was obtained by mixing the merocyanine dye represented by Chemical Formula 4, the merocyanine dye (an absorption maximum wavelength of 590 nm, ε =1.01 × 10⁵), and the coumarin dye represented by Chemical Formula 72 in a molar ratio of 39:46:15.

The photosensitizing composition of this example is useful as a material for sensitizing semiconductor electrodes in photoelectric conversion elements such as solar cells, as well as for photosensitizing polymerization compounds and polymerization initiators in photochemical polymerization.

### Example 3

### Semiconductor electrode

Semiconductor electrodes were obtained by binding nano-sized particles of titanium, an average particle size of 23 nm, and those of titanium oxide, an average particle size of 12 nm, in a weight ratio of 4:1; dispersing the resultant in a 20%(w/w) aqueous polyethylene glycol solution; coating the resultant suspension onto either surface of usual glass substrates having an electroconductivity to give a thickness of about six micrometers; drying the coated substrates; and sintering the dried substrates at 450°C for 30 minutes.

Separately, either of the photosensitizing compositions, obtained by the methods of Examples 1 and 2, was dissolved in ethanol to give a concentration of 1 × 10⁻⁴ M as a total concentration of the organic compounds. Two types of semiconductor electrodes, sensitized with the photosensitizing compositions according to this invention, were obtained by soaking the semiconductor electrodes thus obtained in the above ethanol solution; allowing the soaked electrodes to stand at ambient temperature for 12 hours; taking out the electrodes from the solution; and drying the resultant electrodes.

The semiconductor electrodes of this example are advantageously useful as semiconductor electrodes for composing photoelectric conversion elements, for example, photoelectrochemical solar cells.

### Example 4

### Photoelectric conversion element

Two types of photoelectric conversion elements were obtained with the method disclosed in the specification of International Application No. PCT/JP01/11381 (International Publication No. WO02/052654, titled "Solar cells") published under the Patent Cooperation Treaty, applied for by the same applicant as this invention, by installing either of two types of semiconductor electrodes prepared by the method in Example 3 and a counter electrode prepared by sputtering platinum on the surface of an electroconductive glass substrate having a tin oxide layer admixed with a small amount of fluorine to give a thickness of 100 nm with a usual manner, inside a cell; installing a spacer of a usual ionomer resin, "HIMILAN®", a product of Du Pont-Mitsui Polychemicals, Co., Ltd., Tokyo, Japan, inside the cell to avoid physical contact between the semiconductor and the counter electrode; and injecting a redox electrolyte (an acetonitrile solution containing 45 mM iodine, 30 mM lithium iodide, 330 mM dimethylhexyl imidazolium=iodide, and 0.1 mM 4-*tert*-butylpyridine) into the resultant cell.

### Example 5

### Photoelectric conversion property of photoelectric conversion element

Two types of the photoelectric conversion elements in Example 4 were examined for photoelectric conversion properties in a usual manner. As a light source, it was used a usual solar simulator (an air mass of 1.5, an illumination of 94,500 lux, and a radiation energy intensity of 82 mW/cm²) with a xenon lamp and a band pass filter. In parallel, photoelectric conversion elements as controls, prepared similarly as in Example 4 except for using any one of the merocyanine dyes or the coumarin dyes, represented by Chemical Formula 4, 21, or 72, alone; or using the cyanine dye represented by Chemical Formula 80, which had absorption characteristics similar to those of the merocyanine dye represented by Chemical Formula 21, in place of the dye of Chemical Formula 21, were examined for photoelectric conversion properties similarly as in the above. Table 1 shows the results.

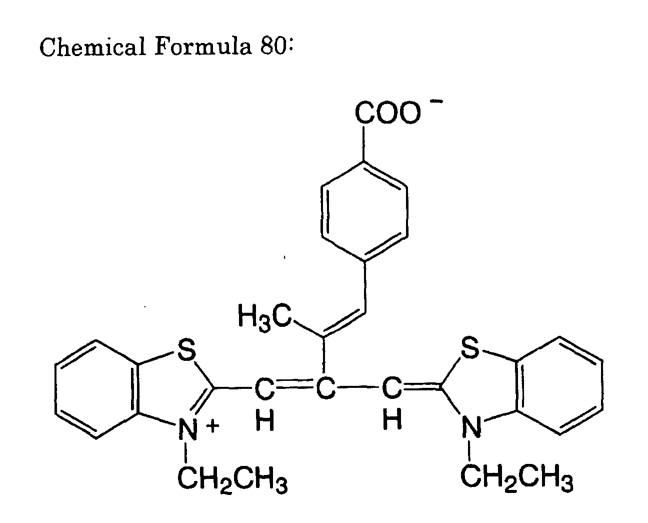

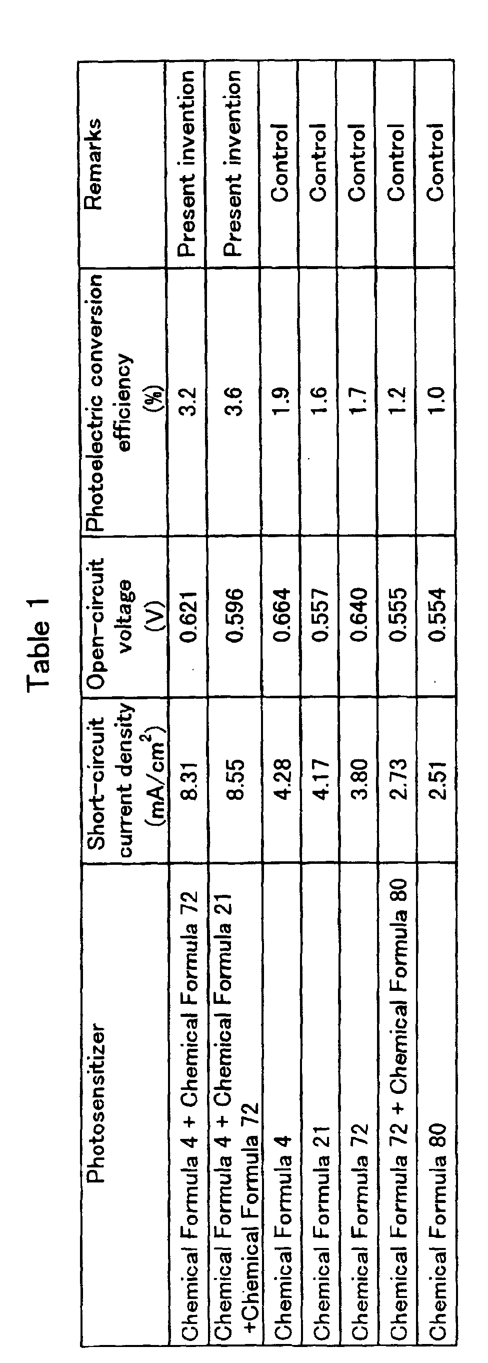

As evident from the results in Table 1, the photoelectric conversion elements used in combination with the merocyanine dyes and coumarin dyes according to this invention were superior to the control photoelectric conversion elements in both short-circuit current density and photoelectric conversion efficiency. The short-circuit current density and the photoelectric conversion efficiency in the control photoelectric conversion elements were respectively 2.51 to 4.28 mA/cm² and 1.0 to 1.9%: While, the tested photoelectric conversion elements according to this invention had a significantly higher short-circuit current density of 8.31 to 8.55 mA/cm² and a photoelectric conversion efficiency of 3.2 to 3.6% than those of the control photoelectric conversion elements. As evident from the results in Table 1, the control photoelectric conversion elements, used in combination with the cyanine dye represented by Chemical Formula 80 in place of the coumarin compound and the merocyanine dye represented by Chemical Formulae 72 and 4, respectively, had an apparently lower short-circuit current density and photoelectric conversion efficiency than those of the photoelectric conversion elements, used in combination with the merocyanine dye and the coumarin dye represented by Chemical Formula 4 and 72, respectively according to this invention. The fact really indicates that the photoelectric conversion efficiency of photosensitizing compositions is not necessarily equal to that of organic compounds for use in the photosensitizing compositions when the compositions are prepared in combination with a plurality of absorptive organic compounds.

These results show that a higher photoelectric conversion efficiency which has never been easily attained by using either of the merocyanine and coumarin dyes is succeeded by a combination use of the dyes as photosensitizers in photoelectric conversion elements according to this invention.

### Industrial Applicability

As explained above, the photosensitizing compositions comprising merocyanine and coumarin dyes according to this invention efficiently absorb light energy in the extended visible region. The photosensitizing compositions attain a higher photoelectric conversion efficiency that has never been easily attained by using either of a merocyanine dye and a coumarin dye when used in a photoelectric conversion element such as solar cells, in particular, photoelectrochemical solar cells. In addition, the compositions are useful as a sensitizer for sensitizing polymerizable compounds and polymerization initiators, as well as for photochemically polymerizing the polymerizable compounds.

This invention with such outstanding effects is a significant invention that would greatly contribute to this art.

## Claims

1. A photosensitizing composition which comprises a merocyanine dye and a coumarin dye.

2. The photosensitizing composition according to claim 1, wherein said merocyanine dye is represented by any one of General Formulae 1 to 3: 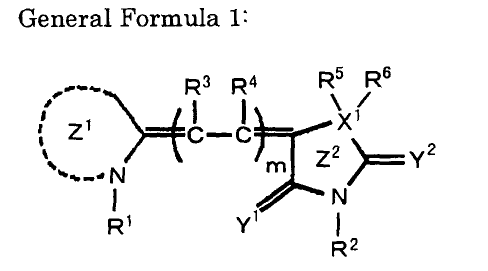 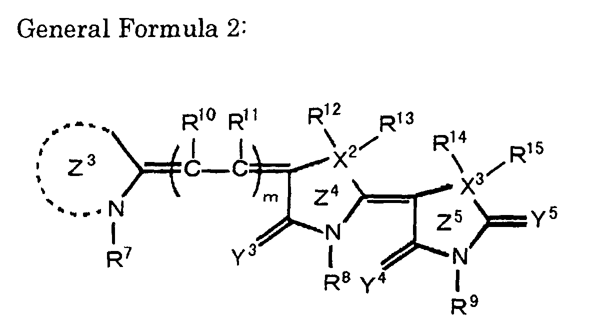 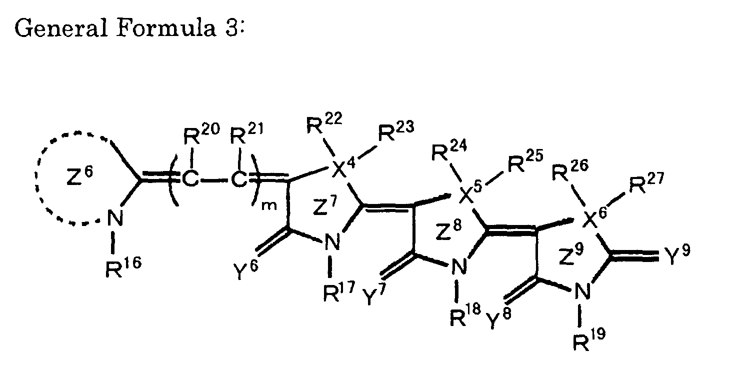 (In General Formulae 1 to 3, Z¹ to Z⁹ independently denote the same or different heterocycle, which may bear a substituent; X¹ to X⁶ independently denote carbon atom or a heteroatom; Y¹ to Y⁹ independently denote the same or different heteroatom; R¹ to R²⁷ independently denote hydrogen atom or a substituent; in case that X¹ to X⁶ are heteroatoms, R⁵ to R⁶, R¹² to R¹⁵, and R²² to R²⁷ may be absent; the symbol "m" is an integer of zero or over; and in case that "m" is zero, R³, R⁴, R¹⁰, R¹¹, R²⁰, and R²¹ are absent.)

3. The photosensitizing composition according to claim 1 or claim 2, wherein said coumarin dye is represented by General Formula 4: 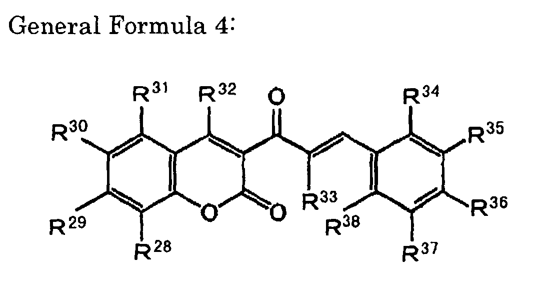 (In General Formula 4, R²⁸ to R³⁸ independently denote hydrogen atom or a substituent.)

4. A semiconductor electrode sensitized with the photosensitizing composition as defined in any of claims 1 to 3.

5. A photoelectric conversion element, comprising a photosensitizing composition as defined in any of claims 1 to 3.

6. A solar cell comprising a photosensitizing composition as defined in any of claims 1 to 3.

7. The solar cell according to claim 6, which comprises a photoelectrochemical solar cell.

8. Use of a composition as defined in any of claims 1 to 3 as a photosensitizing agent.

9. Use of a composition as defined in any of claims 1 to 3 for sensitizing a semiconductor electrode.

10. Use of a composition as defined in any of claims 1 to 3 in a photoelectric conversion element.

11. Use of a composition as defined in any of claims 1 to 3 in a solar cell.

12. Use according to claim 11, wherein said solar cell comprises a photoelectrochemical solar cell.
